(19) Europäisches Patentamt
European Patent Office
Office européen des brevets

(11) **EP 2 826 794 A1**

(12) # EUROPEAN PATENT APPLICATION
published in accordance with Art. 153(4) EPC

(43) Date of publication:
**21.01.2015 Bulletin 2015/04**

(21) Application number: **13763775.7**

(22) Date of filing: **08.03.2013**

(51) Int Cl.:
***C08F 2/44*** *(2006.01)* ***C09K 11/08*** *(2006.01)*
***H01L 31/04*** *(2014.01)*

(86) International application number:
**PCT/JP2013/056539**

(87) International publication number:
**WO 2013/141048 (26.09.2013 Gazette 2013/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **21.03.2012 JP 2012063499**
**21.03.2012 JP 2012063500**
**07.08.2012 JP 2012174900**
**07.08.2012 JP 2012174903**
**21.08.2012 JP 2012182280**

(71) Applicant: **Hitachi Chemical Company, Ltd.**
**Chiyoda-ku**
**Tokyo 100-6606 (JP)**

(72) Inventors:
- **SAWAKI, Taku**
**Tsukuba-shi**
**Ibaraki 300-4247 (JP)**
- **OKANIWA, Kaoru**
**Tsukuba-shi**
**Ibaraki 300-4247 (JP)**
- **YAMASHITA, Takeshi**
**Tsukuba-shi**
**Ibaraki 300-4247 (JP)**

(74) Representative: **Hoffmann Eitle**
**Patent- und Rechtsanwälte PartmbB**
**Arabellastraße 30**
**81925 München (DE)**

(54) **INORGANIC PHOSPHOR-CONTAINING POLYMER PARTICLES, METHOD FOR PRODUCING INORGANIC PHOSPHOR-CONTAINING POLYMER PARTICLES, AND SOLAR CELL MODULE**

(57) Inorganic phosphor-containing polymer particles that include an inorganic phosphor and a transparent material. The transparent material is preferably a vinyl resin that is a polymer of a vinyl compound. It is preferable that the vinyl compound includes 10% by mass or more of a vinyl compound having a viscosity (at 25°C) of from 5 mPa.s to 30 mPa.s, or includes at least one of a compound having a structure represented by the following Formula (I-1) or the following Formula (I-2). In Formulae (I-1) and (I-2), each of $R^1$ and $R^2$ independently represents a hydrogen atom or an alkyl group. $R^1$ and $R^2$ may be linked to each other to form a ring. The inorganic phosphor is preferably surface-modified with a surface treatment agent, more preferably surface-modified with a coupling agent, still more preferably surface-modified with a silicone oligomer having a reactive substituent.

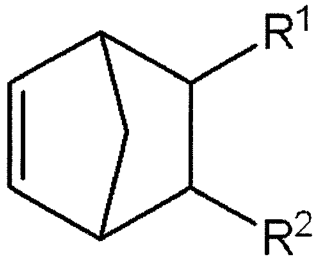

(I-1)

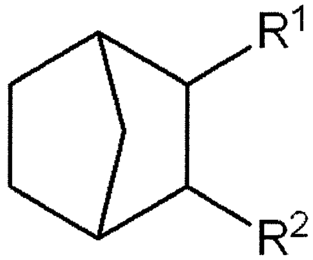

(I-2)

EP 2 826 794 A1

Fig. 1

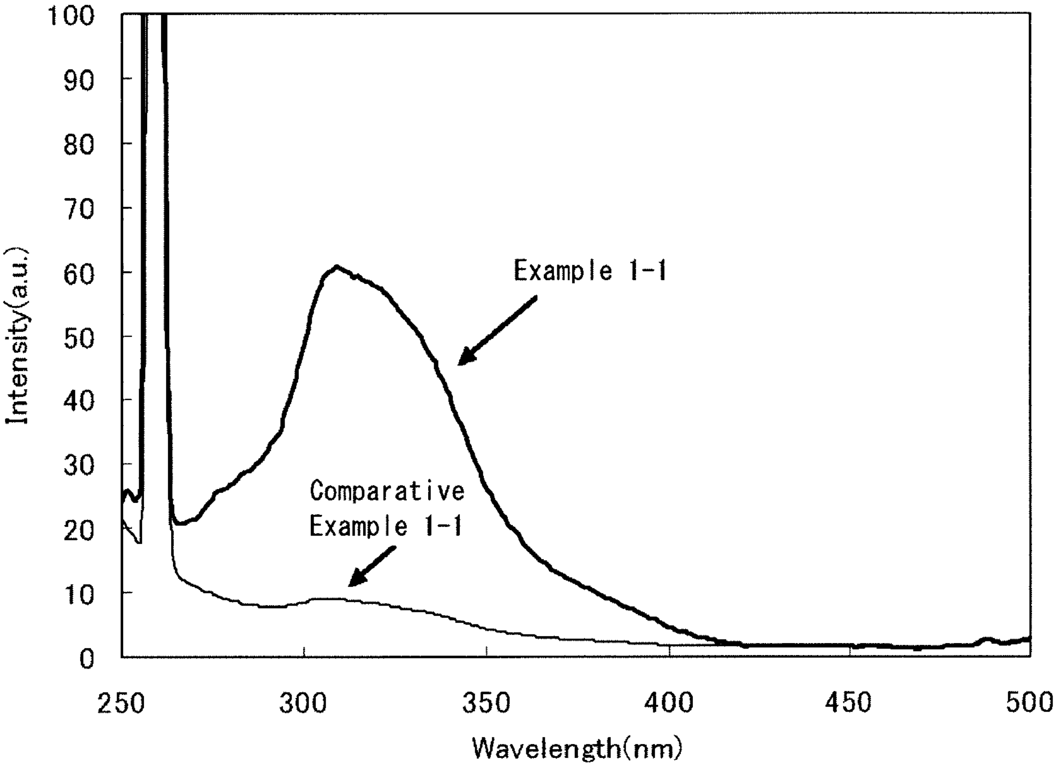
100
90
80
70
60
50
40
30
20
10
0
Intensity(a.u.)
Example 1-1
Comparative
Example 1-1
250
300
350
400
450
500
Wavelength(nm)

## Description

### Technical Field

This invention relates to inorganic phosphor-containing polymer particles, a method for producing inorganic phosphor-containing polymer particles, and a photovoltaic cell module.

### Background Art

In general, methods of producing polymer particles by radical polymerization are broadly divided into emulsion polymerization and suspension polymerization.

The emulsion polymerization is a polymerization method in which lipophilic monomers are emulsified in water with an emulsifier and polymerized with a water-soluble initiator. At an initial stage of the emulsion polymerization, monomers in micelles or monomers dissolved in minute amounts in water are polymerized in water by radicals generated from a water-soluble initiator. The polymers generated precipitate from water to form numerous microparticles in the system. Since the microparticles have a large interfacial area, the system becomes colloidally unstable. Therefore, the microparticles form an aggregate until the interfacial area is small enough for the microparticles to stably exist in the system. This process is generally completed at an initial stage of within several percentage of a polymerization conversion rate.

After that, the number of the aggregated particles do not largely change and the monomers in the micelles are gradually eluted into water, and polymerization is continued while the monomers and the radicals infiltrate into the aggregated particles by molecular diffusion via water. As a result, the polymer particles during the polymerization grow gradually until the polymerization is completed. In general, the polymer particles obtained by emulsion polymerization have an average particle diameter of from approximately 0.05 $\mu$m to 0.5 $\mu$m, and a relatively narrow particle size distribution.

However, since emulsion polymerization is a system in which monomers diffuse into water and migrate into aggregated particles at the most of its stages, it is difficult to incorporate an inorganic material in the polymer particles by emulsion polymerization. Even if monomers mixed with an inorganic material are subjected to emulsion polymerization, only the monomers migrate into aggregated particles while the inorganic material is left in water.

On the other hand, suspension polymerization is a method in which polymerization is performed by dispersing lipophilic monomers in which an oil-soluble initiator has been preliminarily dissolved in water that contains a suspension protection agent or an emulsifier. In general, polymer particles obtained by suspension polymerization have a large average particle diameter, such as from several micrometers to several hundred micrometers, and have a broad particle size distribution. In the suspension polymerization, it is relatively easy to produce inorganic material-containing polymer particles by mixing an inorganic material with the monomers in advance.

Japanese Patent Application Laid-Open (JP-A) No. H10-110004 discloses a method of obtaining an inorganic material-containing vinyl chloride resin by performing suspension polymerization of vinyl chloride monomers in the presence of an inorganic material. JP-A No. S63-65085 discloses a process to attach or bond an inorganic material to surfaces of preliminarily synthesized polymer particles.

Hereinbelow, conventional silicon photovoltaic cell modules are explained. The conventional silicon photovoltaic cell modules are configured as follows. That is, as a surface protection glass (also referred to as a "cover glass"), tempered glass is used in consideration of resistance to shock. On one side of the protection glass, an asperity pattern is formed by embossment to improve adhesion of the protection glass to a sealing material (which is usually a resin containing an ethylene-vinyl acetate copolymer as a main component, also referred to as a filler). The asperity pattern is formed at the side of a photovoltaic cell module, so that the top surface of the photovoltaic cell module is smooth. Under the protection glass, a sealing material for protecting and sealing photovoltaic cell elements and tabbing wires, and a back film are provided.

For example, JP-A No. 2003-218379 proposes a method in which the wavelength of light in a UV region or an infrared region in sunlight spectrum, which does not contribute to electricity generation, is converted by a phosphor (also referred to as a light emission material) by providing a layer that emits light in a wavelength region that contributes to electricity generation at the light-receiving surface side of a photovoltaic cell. JP-A No. 2006-303033 proposes a method of incorporating a rare-earth complex as a phosphor in a sealing material.

### Summary of the Invention

### Technical Problem

However, there are some restrictions in suspension polymerization in that, for example, the amount of an

inorganic material that can be included in polymer particles is small, and that the inorganic material needs to have a small average particle diameter and a high level of dispersibility in a monomer.

In the method described in JP-A No. H10-110004, the inorganic material migrates into water during performing suspension polymerization in an aqueous medium. Therefore, it is necessary to use an excess amount of inorganic material in order that a specific amount thereof is incorporated in polymer particles, which is a disadvantage in terms of production costs. In the method described in JP-A No. H10-110004, since a part of an inorganic material precipitates without being incorporated in polymer particles, a process of separating the inorganic material and the polymer particles needs to be performed after the polymerization. In addition, there is a difficulty in incorporating a large amount of an inorganic material into the polymer particles.

In the method described in JP-A No. S63-65085, there is a problem in that the performances of polymer particles may deteriorate because of an inorganic material that exists on the surfaces of the polymer particles.

The wavelength conversion layer that converts light that does not contribute to power generation into light in a wavelength range that contributes to power generation, as described in JP-A No. 2003-218379, contains a phosphor. Since the phosphor is generally large in size, the incident sunlight that reaches the photovoltaic cell element through the wavelength conversion layer is not sufficient, thereby increasing the proportion of sunlight that does not contribute to power generation. Therefore, there is a problem in that the proportion of electric power generated (efficiency of power generation) with respect to energy from incident sunlight is not increased so much in spite of converting ultraviolet light into visible light with the wavelength conversion layer.

In the method described in JP-A No. 2003-218379, there is a problem in that the efficiency is lower than a case in which no phosphor is contained. None of the above proposals has been applied to actual photovoltaic cell modules, in the present situation. The reason is that these proposals only focus on an idea of converting the wavelength of ultraviolet light or infrared light in the sunlight spectrum that does not contribute to power generation, and there is no attention on suppressing a scattering loss that is caused by the phosphor.

In the method described in JP-A No. 2006-303033, a sufficient durability cannot be obtained because of a rare-earth complex used therein. Therefore, it is difficult to maintain the functions of the wavelength conversion material over a long period of time.

An object of the invention is to provide inorganic phosphor-containing polymer particles in which an inorganic phosphor is included in the polymer particles, and to provide a method of producing the inorganic phosphor-containing polymers in a convenient manner.

A further object of the invention is to provide a photovoltaic cell module having an excellent durability, in which the light utilization efficiency in the photovoltaic cell module can be improved and a power generating efficiency can be stably improved over a long period of time.

Solution to Problem

The present invention is as follows.

<1> Inorganic phosphor-containing polymer particles, the particles comprising:

an inorganic phosphor that is surface-modified with a surface treatment agent; and
a transparent material.

<2> The inorganic phosphor-containing polymer particles according to <1>, wherein the surface treatment agent is a coupling agent.

<3> The inorganic phosphor-containing polymer particles according to <2>, wherein the coupling agent is at least one selected from the group consisting of a silane coupling agent, a titanate coupling agent and an aluminate coupling agent.

<4> The inorganic phosphor-containing polymer particles according to <1>, wherein the surface treatment agent comprises a silicone oligomer having a reactive substituent.

<5> The inorganic phosphor-containing polymer particles according to any one of <1> to <4>, wherein the transparent material comprises a vinyl resin that is a polymer of a vinyl compound.

<6> The inorganic phosphor-containing polymer particles according to <5>, wherein the transparent vinyl resin comprises a (meth)acrylic resin.

<7> The inorganic phosphor-containing polymer particles according to <5> or <6>, wherein the vinyl compound comprises a vinyl compound having a viscosity (at 25°C) of from 5 mPa·s to 30 mPa·s in an amount of 10% by mass or more with respect to a total mass of the vinyl compound.

<8> The inorganic phosphor-containing polymer particles according to any one of <5> to <7>, wherein the vinyl compound comprises a (meth)acrylic acid derivative having an alicyclic structure.

<9> The inorganic phosphor-containing polymer particles according to any one of <5> to <8>, wherein the vinyl compound comprises at least one of a compound having a structure represented by following Formula (1-1) or a compound having a structure represented by following Formula (I-2):

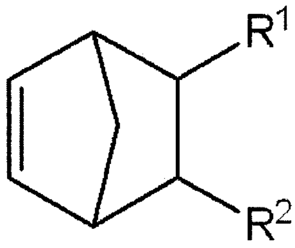

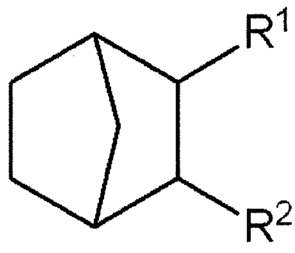

(I-1) (I-2)

wherein, in Formula (I-1) and Formula (I-2), each of $R^1$ and $R^2$ independently represents a hydrogen atom or an alkyl group, and $R^1$ and $R^2$ may be linked to each other to form a ring.

<10> The inorganic phosphor-containing polymer particles according to <9,> wherein the vinyl compound comprises at least one of a compound having a structure represented by following Formula (1) or a compound having a structure represented by following Formula (2):

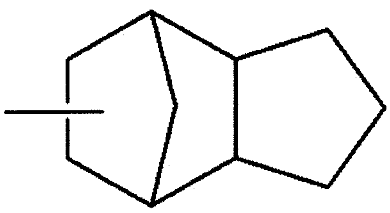

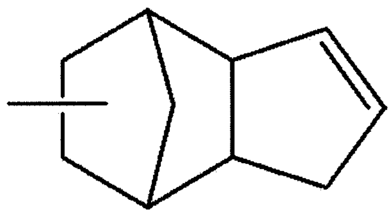

(1) (2)

<11> The inorganic phosphor-containing polymer particles according to <9> or <10>, wherein the vinyl compound comprises at least one selected from (meth)acrylate compounds represented by following Formula (II):

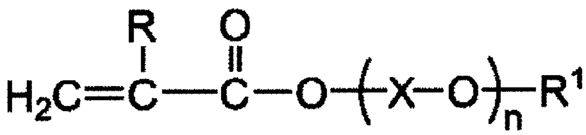

(II)

wherein, in Formula (II), R represents a hydrogen atom or a methyl group; X represents an alkylene group having 1 to 5 carbon atoms; $R^1$ represents following Formula (1) or Formula (2); and n represents an integer from 0 to 10:

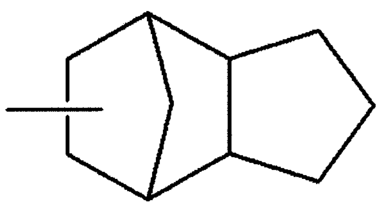

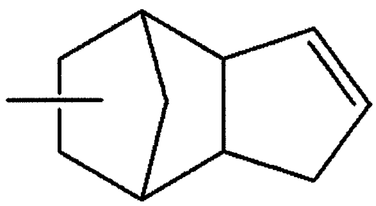

(1) (2)

<12> The inorganic phosphor-containing polymer particles according to any one of <5> to <11>, wherein the vinyl

compound comprises a bi- or poly-functional vinyl compound.
<13> The inorganic phosphor-containing polymer particles according to any one of <5> to <12>, the particles being an emulsion polymer or a suspension polymer, of a composition comprising the inorganic phosphor and the vinyl compound.
<14> The inorganic phosphor-containing polymer particles according to any one of <5> to <12>, the particles being a pulverized product of a bulk polymer of a composition comprising the inorganic phosphor and the vinyl compound.
<15> The inorganic phosphor-containing polymer particles according to any one of <1> to <14>, wherein a content of the inorganic phosphor is from 0.001% by mass to 10% by mass.
<16> The inorganic phosphor-containing polymer particles according to any one of <1> to <15>, the particles having a volume average particle diameter of from 1 μm to 200 μm.
<17> The inorganic phosphor-containing polymer particles according to any one of <1> to <16>, which are a wavelength conversion material for a photovoltaic cell.
<18> A method of producing the inorganic phosphor-containing polymer particles according to any one of <5> to <17>, the method comprising:

a process of surface-modifying an inorganic phosphor with a surface treatment agent;
a process of preparing a composition comprising the inorganic phosphor that has been surface-modified, a vinyl compound, and a radical polymerization initiator; and
a process of performing radical polymerization of the composition.

<19> The method of producing the inorganic phosphor-containing polymer particles according to <18>, wherein the radical polymerization is suspension polymerization in which inorganic phosphor-containing polymer particles having a volume average particle diameter of from 10 μm to 200 μm are synthesized.
<20> A photovoltaic cell module that comprises a photovoltaic cell element and at least one light transmissive layer, wherein any one of the at least one light transmissive layer disposed on a light-receiving surface side of the photovoltaic cell element comprises the inorganic phosphor-containing polymer particles according to any one of <1> to <17>.

Advantageous Effects of the Invention

According to the invention, it is possible to provide inorganic phosphor-containing polymer particles in which an inorganic phosphor is included in polymer particles, and a method of producing the inorganic phosphor-containing polymer particles in a convenient manner.
Furthermore, according to the invention, it is possible to provide a photovoltaic cell module having an excellent durability, in which the light utilization efficiency in the photovoltaic cell module can be improved and a power generating efficiency can be stably improved over a long period of time.

Brief Description of the Drawings

Fig. 1 shows excitation spectra of the inorganic phosphor-containing polymer particles obtained in Example 1-1 and Comparative Example 1-1 at a fluorescence wavelength of 516 nm.
Fig. 2 shows excitation spectra of the inorganic phosphor-containing polymer particles obtained in Examples 2-1 to 2-3 at a fluorescence wavelength of 516 nm.
Fig. 3 shows excitation spectra of the inorganic phosphor-containing polymer particles obtained in Examples 4-1 and 4-2 at a fluorescence wavelength of 516 nm.
Fig. 4 shows excitation spectra of the inorganic phosphor-containing polymer particles obtained in Examples 5-1, 5-3 and 5-4 at a fluorescence wavelength of 626 nm.
Fig. 5 shows excitation spectra of the inorganic phosphor-containing polymer particles obtained in Examples 5-2 and 5-5 at a fluorescence wavelength of 624 nm.

Description of Embodiments

Hereinbelow, the invention is described in detail.

In the specification, "(meth)acrylic acid" refers to acrylic acid or methacrylic acid, "(meth)acryloyl" refers to acryloyl or methacryloyl, "(meth)acrylate" refers to acrylate or methacrylate, and "(meth)acrylic resin" refers to acrylic

resin or methacrylic resin.

The term "process" as used herein indicates not only a separate process but also a process that is not clearly distinguished from other process as long as the desired effect of the process is obtained therefrom. Furthermore, in this specification, each numerical range specified using "(from)... to ..." represents a range including the numerical values noted before and after "to" as the minimum value and the maximum value, respectively.

When plural kinds of substances that correspond to the same component exist in a composition, the amount of the component in the composition refers to the total mass of the plural kinds of substances, unless otherwise specified.

<Inorganic Phosphor-Containing Polymer Particles>

The inorganic phosphor-containing polymer particles according to the invention include an inorganic phosphor that is surface-modified with a surface treatment agent, and a transparent material.

By surface-modifying an inorganic phosphor with a surface treatment agent, dispersibility of the inorganic phosphor in a transparent material is improved, and the amount of inorganic phosphor to be incorporated into the polymer particles can be increased.

Further, by making the wavelength conversion material for a photovoltaic cell module into a shape of particles (polymer particles) that include the phosphor and the transparent material, light that does not contribute to power generation among incident sunlight is converted into light of a wavelength that contributes to power generation, and scattering of sunlight due to a phosphor is suppressed, whereby the incident sunlight can be introduced into the photovoltaic cell efficiently. Furthermore, by using an inorganic phosphor as the phosphor, durability can be improved.

In general, in a case in which an inorganic phosphor is dispersed in a wavelength conversion layer of a photovoltaic cell module, scattering of light occurs in the whole wavelength conversion layer. On the other hand, in a case in which an inorganic phosphor is incorporated into polymer particles that are dispersed in a wavelength conversion layer, scattering is confined to a limited space in the wavelength conversion layer, thereby suppressing occurrence of light scattering at a large part of the wavelength conversion layer.

<Inorganic Phosphor>

The inorganic phosphor is not particularly limited as long as it is an inorganic material that exhibits fluorescence. Since the role to be played by the inorganic phosphor varies depending on the kind of a monomer that constitutes the transparent material, the intended use of the inorganic phosphor-containing polymer particles, or the like, a preferable particle size distribution of the inorganic phosphor or the like also varies. The volume average particle diameter of the inorganic phosphor is generally in a range of from 0.01 μm to 100 μm, and preferably in a range of from 0.1 μm to 50 μm. In a case in which the volume average particle diameter is 0.01 μm or more, a sufficient emission intensity tends to be obtained. In a case in which the volume average particle diameter is 100 μm or less, it is easier to introduce the inorganic phosphor into the polymer particles.

In the invention, the volume average particle diameter refers to a value measured with a laser diffraction scattering particle size distribution measuring apparatus (for example, trade name: LS13320, manufactured by Beckman Coulter, Inc.)

Examples of the type of the inorganic phosphor include calcium halophosphate phosphors, phosphate phosphors, aluminate phosphors, zinc sulfide phosphors, zinc oxide phosphors, and rare-earth oxide phosphors. Specific examples of the representative inorganic phosphor for practical use include, as indicated by "basal composition : activating agent", X-ray or radiation-excited phosphors such as NaI:Ti, $CaWO_4$:Pb and $Gd_2O_2S$:Tb; UV ray-excited phosphors such as $BaSi_2O_5$:Pb, $Sr_2P_2O_7$:Eu, $BaMg_2Al_{16}O_{27}$:Eu, $BaMg_2Al_{16}O_{27}$:Eu, Mn, $BaMgAl_{10}O_{17}$:Eu, Mn, $MgWO_4$:Pb, $3Ca_3(PO_4)_2{\cdot}Ca(F, Cl)_2$:Sb, Mn, $MgGa_2O_4$:Mn, 0.5MgF2·3.5MgO·$GeO_2$:Mn, $Ga_2O_4$:Mn, $Zn_2SiO_4$:Mn, $MgAl_{11}O_{19}$:Ge, Tb, $Y_2SiO_5$:Ce, Tb, $Y_2O_2S$:Eu, $Y_2O_3$:Eu, $YVO_4$:Eu, $(Sr, Mg, Ba)_3(PO_4)_2$:Sn and 3.5Mg·5$MgF_2{\cdot}GeO_2$:Mn; UV-visible light-excited phosphors such as ZnS:Cu; and electron beam-excited phosphors such as $Y_2SiO_5$:Ce, ZnS:Ag, ZnO:Zn, $Zn_2SiO_4$:Mn, As, ZnS:Cu, Al, ZnS:Cu, Au, Al, (Zn, Cd)S:Cu, Al, (ZnS:Ag) + ((Zn, Cd)S:Cu) and $Y_2O_2S$:Eu.

<Surface Treatment Agent>

The inorganic phosphor is surface modified with a surface treatment agent in order to improve its dispersibility in a transparent material. By using surface-modified inorganic phosphor, it becomes possible to increase the amount of the inorganic phosphor to be incorporated into polymer particles.

The surface modification can be performed by subjecting the inorganic phosphor to surface treatment (or coating treatment) with a surface treatment agent or the like. The surface treatment agent is not particularly limited as long as it can improve the dispersibility of the inorganic phosphor in the transparent material.

Specific examples of the surface treatment agent include silica (including silica produced by a sol-gel method

with a tetraalkoxysilane, for example, a tetra $C_{1-4}$ alkoxysilane such as tetramethoxysilane, or an oligomer thereof), coupling agents and polyorganosiloxanes. The surface treatment agent may be used singly or in combination of two or more kinds thereof.

The tetra $C_{1-4}$ alkoxysilane refers to a tetraalkoxysilane in which the alkoxy group has 1 to 4 carbon atoms. Hereinbelow, "$C_{n-m}$" refers to the carbon number of the functional group described immediately after the same, and "n-m" refers to that the range of the carbon number is from n to m.

Examples of the coupling agents include silane coupling agents, titanate coupling agents, aluminate coupling agents and zirconium coupling agents. The coupling agent is preferably at least one selected form the group consisting of silane coupling agents, titanate coupling agents and aluminate coupling agents.

Examples of the silane coupling agents include halogen-containing silane coupling agents (such as 3-chloropropyltrimethoxysilane), epoxy group-containing silane coupling agents (such as 3-glycidyloxypropyltrimethoxysilane), amino group-containing silane coupling agents (such as 2-aminoethyltrimethoxysilane), mercapto-group containing silane coupling agents (such as 3-mercapropropyltrimethoxysilane), vinyl group-containing silane coupling agents (such as vinyltrimethoxysilane) and (meth)acryloyl group-containing silane coupling agents (such as 2-(meth)acryloxyethyltrimethoxysilane).

Examples of the titanate coupling agents include a titanate coupling agent at least having an alkylate group of 1 to 60 carbon atoms, a titanate coupling agent having an alkylphosphite group, a titanate coupling agent having an alkylphosphate group, and a titanate coupling agent having an alkylpyrophosphate group.

Specific examples of the titanate coupling agents include isopropyltriisostearoyl titanate, isopropyltrioctanoyl titanate, isopropyldimethacrylisostearoyl titanate, isopropylisostearoyldiacryl titanate, isopropyl tris(dioctylpyrophosphate) titanate, tetraoctyl bis(ditridecylphosphite) titanate, tetra(2,2-diallyloxymethyl-1-butyl) bis(ditridecyl)phosphite titanate, bis(dioctylpyrophosphate)oxyacetate titanate and bis(dioctylpyrophosphate)ethylene titanate.

Examples of the aluminate coupling agents include acetoalkoxyaluminum diisopropylate, aluminum diisopropoxymonoethylacetoacetate, aluminum trisethylacetoacetate and aluminum trisacetylacetonate.

Examples of the polyorganosiloxanes include polydialkylsiloxanes (for example, a poly di-$C_{1-10}$ alkylsiloxane, such as polydimethylsiloxane (dimethycone), preferably a poly di-$C_{1-4}$ alkylsiloxane); polyalkylalkenylsiloxanes (a poly $C_{1-10}$ alkyl $C_{2-10}$ alkenylsiloxane, such as polymethylvinylsiloxane); polyalkylarylsiloxanes (for example, a poly $C_{1-10}$ alkyl $C_{6-20}$ arylsiloxane, such as polymethylphenylsiloxane, preferably a poly $C_{1-4}$ alkyl $C_{6-10}$ arylsiloxane); polydiarylsiloxanes (a poly di-$C_{6-20}$ arylsiloxane, such as polydiphenylsiloxane); polyalkylhydrogensiloxanes (a poly $C_{1-10}$ alkylhydrogensiloxane, such as polymethylhydrogensiloxane); organosiloxane copolymers (such as a dimethylsiloxane-methylvinylsiloxane copolymer, a dimethylsiloxane-methylphenylsiloxane copolymer, a dimethylsiloxane-methylvinylsiloxane-methylphenylsiloxane copolymer and a dimethylsiloxane-methylhydrogensiloxane copolymer (a dimethicone/methicone copolymer); and modified polyorganosiloxanes (for example, modified polyorganosiloxanes of the above described polyorganosiloxanes, such as a polyorganosiloxane modified with a hydroxy group (e.g., a silanol-terminated polydimethylsiloxane, a silanol-terminated polymethylphenylsiloxane, a hydroxypropyl-terminated polydimethylsiloxane, a polydimethylhydroxyalkyleneoxide methylsiloxane), a polyorganosiloxane modified with an amino group (e.g., a dimethylamino-terminated polydimethylsiloxane, an aminopropyl-terminated polydimethylsiloxane) and a polyorganosiloxane modified with a carboxy group (e.g., a carboxypropyl-terminated polydimethylsiloxane)).

Among these, specific examples of the preferable polyorganosiloxane include a polyorganosiloxane that includes at least one selected from a polydimethylsiloxane (dimethicone) unit or a polymethylhydrogensiloxane (methicone) unit, such as a polydimethylsiloxane (or a dimethicone), a dimethicone/methicone copolymer, and a mixture thereof.

The viscosity of the polyorganosiloxane at 25°C is preferably from 0.5 cSt (centistokes) to 100000 cSt ($0.5 \times 10^{-6}$ $m^2/s$ to 0.1 $m^2/s$), more preferably from 1 cSt to 50000 cSt ($1 \times 10^{-6}$ $m^2/s$ to 0.05 $m^2/s$), still more preferably from 5 cSt to 20000 cSt ($5 \times 10^{-6}$ $m^2/s$ to $2 \times 10^{-2}$ $m^2/s$), further more preferably from 10 cSt to 10000 cSt ($1 \times 10^{-5}$ $m^2/s$ to $1 \times 10^{-2}$ $m^2/s$), and yet more preferably from 10 cSt to 5000 cSt ($1 \times 10^{-5}$ $m^2/s$ to $5 \times 10^{-3}$ $m^2/s$). These surface modification agents (such as a polyorganosiloxane) may be used singly or in combination of two or more kinds thereof.

Examples of the preferable surface modification agent include silicon surface modification agents (such as silica, a silane coupling agent and a polyorganosiloxane).

The ratio of the surface modification agent to the inorganic phosphor is preferably from 0.1% by mass to 70% by mass, more preferably from 0.5% by mass to 50% by mass, and still more preferably from 1% by mass to 30% by mass.

It is preferable to include a silicone oligomer having a reactive substituent group, as the surface treatment agent. It is more preferable that the silicone oligomer having a reactive substituent group has one or more terminal functional groups that can react with a hydroxy group. The molecular weight, the structure and the like of the silicone oligomer having a reactive substituent group are not particularly limited. Examples of the reactive substituent group include a (meth)acryloyl group, a vinyl group, a mercapto group, an epoxy group and an amino group. From the viewpoint of polymerizability, a (meth)acryloyl group, a vinyl group and a mercapto group are preferable. Specific examples of the silicone oligomer having a reactive substituent group include those having an acryloyl group such as KR-513, and X-40-2672B (manufactured by Shin-Etsu Chemical Co., Ltd.) and those having a methacryloyl group such as X-40-9272B

(manufactured by Shin-Etsu Chemical Co., Ltd.)

The content of the silicone oligomer having a reactive substituent group with respect to the inorganic phosphor is preferably from 0.01% by mass to 50% by mass, more preferably from 0.1% by mass to 30% by mass, and still more preferably from 0.2% by mass to 10% by mass.

<Transparent Material>

The inorganic phosphor-containing polymer particles include an inorganic phosphor and a transparent material. Here, being "transparent" refers to having a transmissibility of 90% or more with respect to light at a wavelength of from 400 nm to 800 nm at an optical path length of 1 cm.

The transparent material is not particularly limited as long as the material is transparent, and examples thereof include resins such as a (meth)acrylic resin, a urethane resin, an epoxy resin, polyester, polyethylene, or polyvinyl chloride. Among these, from the view point of suppressing light scattering, a (meth)acrylic resin is preferable. The monomer that constitutes the resin is not particularly limited, and a vinyl compound is preferable from the viewpoint of suppressing light scattering. The vinyl compound may be used singly or in combination of two or more kinds thereof.

The vinyl compound is not particularly limited as long as it includes a compound having at least one ethylenically unsaturated bond. Any acrylic monomer, methacrylic monomer, acrylic oligomer or methacrylic oligomer, which is capable of forming a vinyl resin upon polymerization, especially a (meth)acrylic resin, can be used without any limitation. Preferable examples of the vinyl compound include an acrylic monomer and a methacrylic monomer. Specific examples of the acrylic monomer and the methacrylic monomer include acrylic acid, methacrylic acid, an alkyl acrylate, and an alkyl methacrylate.

The vinyl compound may be appropriately selected in accordance with the intended use of the inorganic phosphor-containing polymer particles to be formed, and is preferably at least one selected from an alkyl acrylate or an alkyl methacrylate. Other vinyl compounds that can be copolymerized with an alkyl acrylate or an alkyl methacrylate may be used in combination.

Examples of the alkyl acrylate and the alkyl methacrylate include unsubstituted alkyl acrylates and unsubstituted alkyl methacrylates, such as methyl acrylate, methyl methacrylate, ethyl acrylate, ethyl methacrylate, butyl acrylate, butyl methacrylate, 2-ethylhexyl acrylate and 2-ethylhexyl methacrylate; dicyclopentenyl (meth)acrylate; tetrahydrofurfuryl (meth)acrylate; benzyl (meth)acrylate; urethane (meth)acrylate (such as a reaction product of tolylene diisocyanate and 2-hydroxyethyl (meth)acrylate, and a reaction product of trimethylhexamethylene diisocyanate, cyclohexanedimethanol and 2-hydroxyethyl (meth)acrylate); and substituted alkyl acrylates and substituted alkyl methacrylates in which an alkyl group of the above exemplary compounds has a substituent such as a hydroxy group, an epoxy group or a halogen group.

Examples of the other vinyl compounds that can be copolymerized with acrylic acid, methacrylic acid, an alkyl acrylate or an alkyl methacrylate include acrylamide, acrylonitrile, diacetoneacrylamide, styrene and vinyltoluene. These vinyl compounds may be used singly or in combination of two or more kinds thereof.

It is preferable to include a vinyl compound having a viscosity at 25°C of from 5 mPa·s to 30 mPa·s (hereinafter, also referred to as a "vinyl compound with a specific viscosity") as the vinyl compound. In a case in which the vinyl compound with a specific viscosity is used, it is possible to suppress detachment of the inorganic phosphor from the polymer particles during growing from a monomer, whereby the inorganic phosphor can be efficiently enclosed in the polymer particles.

In a case in which the viscosity of the vinyl compound is 5 mPa·s or more, it is easier to maintain a dispersed state of the monomer and the inorganic phosphor, and as a result, the amount of the inorganic phosphor to be incorporated into the polymer particles can be further increased and the amount of incorporation can be controlled in an easier manner. In a case in which the viscosity is 30 mPa·s s or less, the particle diameter of the polymer particles to be produced can be easily controlled during suspension polymerization.

In a case in which the vinyl compound with a specific viscosity is used, the content of the vinyl compound with a specific viscosity is preferably 10% by mass or more, more preferably 15% by mass or more, and still more preferably 20% by mass or more, with respect to the total mass of the vinyl compound. The upper limit of the content of the vinyl compound with a specific viscosity with respect to the total mass of the vinyl compound is not particularly limited, and is preferably 90% by mass or less, more preferably 80% by mass of less, and still more preferably 70% by mass of less, from the viewpoint of controlling the particle diameter of the polymer particles to be produced.

It is more preferable that the vinyl compound with a specific viscosity has a viscosity of from 8 mPa·s to 20 mPa·s.

Examples of the vinyl compound with a specific viscosity include 2-hydroxyethyl methacrylate, 2-hydroxypropyl methacrylate, 3-chloro-2-hydroxypropyl methacrylate, cyclohexyl methacrylate, dicyclopentenyl methacrylate, dicyclopentenyl oxyethyl methacrylate, pentamethyl piperidyl methacrylate, ethyleneglycol dimethacrylate and dicyclopentenyl acrylate.

The viscosity is measured with a rotational viscometer (a single cylinder-type rotational viscometer or a conical

plate-type rotational viscometer). The measurement is preferably carried out using a conical plate-type rotational viscometer (cone plate-type), since the measurement can be carried out with a small quantity of a sample.

The vinyl compound preferably includes a (meth)acrylic acid derivative having an alicyclic structure. Examples of the (meth)acrylic acid derivative having an alicyclic structure include dicyclopentanyl acrylate, dicyclopentanyl methacrylate, dicyclopentenyl acrylate, 2-(dicyclopentenyloxy)ethyl acrylate, 2-(dicyclopentenyloxy)ethyl methacrylate, isobornyl acrylate, isobornyl methacrylate, cyclohexyl acrylate, cyclohexyl methacrylate, t-butylcyclohexyl acrylate and t-butylcyclohexyl methacrylate.

The vinyl compound having an alicyclic structure preferably includes at least one of a compound having a structure represented by following Formula (I-1) or a compound having a structure represented by following Formula (I-2).

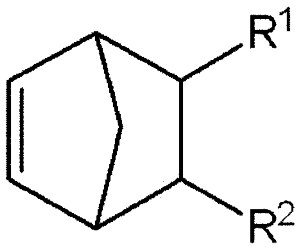

(I-1)

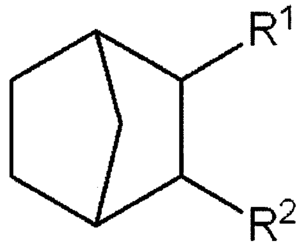

(I-2)

In Formulae (1-1) and (I-2), each of $R^1$ and $R^2$ independently represents a hydrogen atom or an alkyl group. $R^1$ and $R^2$ may be linked to each other to form a ring.

It is preferable that each of $R^1$ and $R^2$ independently represents an alkyl group, and it is more preferable that $R^1$ and $R^2$ are linked to each other to form a ring. The ring formed by the linking of $R^1$ and $R^2$ is preferably cyclopentane, cyclohexane, cycloheptane or cyclooctane, and more preferably cyclopentane.

It is preferable that the vinyl compound includes at least one of a compound having a structure represented by following Formula (1) or a compound having a structure represented by following Formula (2).

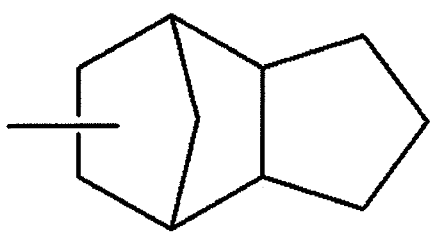

(1)

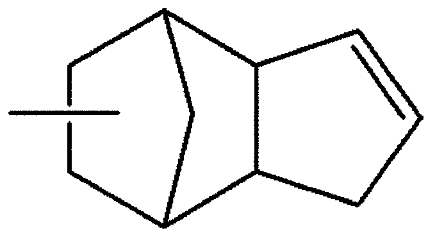

(2)

It is more preferable that the vinyl compound includes at least one selected from (meth)acrylate compounds represented by following Formula (II).

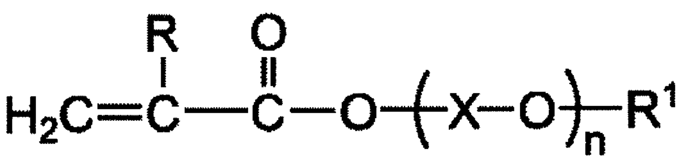

(II)

In Formula (II), R represents a hydrogen atom or a methyl group; X represents an alkylene group having from 1 to 5 carbon atoms; $R^1$ represents following Formula (1) or (2); and n represents an integer of 0 to 10.

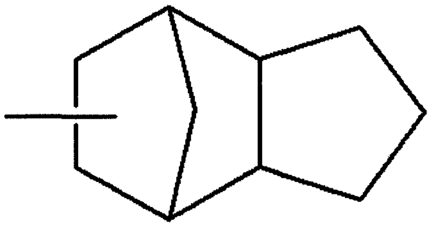

(1)

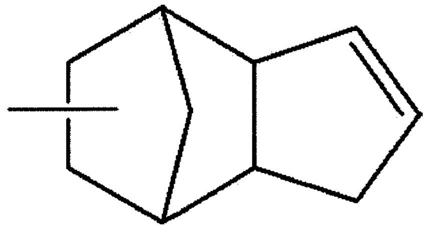

(2)

In Formula (II), X represents an alkylene group having from 1 to 5 carbon atoms, preferably represents an alkylene group having from 1 to 3 carbon atoms, and more preferably represents ethylene.

Examples of the compound having a structure represented by Formula (1-1) or (I-2) include dicyclopentenyloxyethyl acrylate, dicyclopentenyloxyethyl methacrylate, dicyclopentanyloxyethyl acrylate, dicyclopentanyloxyethyl methacrylate, dicyclopentenyl acrylate, dicyclopentenyl methacrylate, dicyclopentanyl acrylate and dicyclopentanyl methacrylate. The compounds are commercially available as FA-5111AS (dicyclopentenyl acrylate), FA-512AS (dicyclopentenyloxyethyl acrylate), FA-513AS (dicyclopentanyl acrylate), FA-512M (dicyclopentenyloxyethyl methacrylate) and FA-513M (dicyclopentanyl methacrylate) (all trade names, manufactured by Hitachi Chemical Company, Ltd.)

In a case in which the compound having a structure represented by at least one of Formula (I-1) or Formula (I-2) is used, the content of the compound is preferably from 1% by mass to 90% by mass, more preferably from 5% by mass to 80% by mass, and still more preferably from 10% by mass to 70% by mass, with respect to the total mass of the vinyl compound.

It is preferable that the vinyl compound includes a bi- or poly-functional vinyl compound. In a case in which the bi- or poly-functional vinyl compound is used, the compounding ratio thereof is preferably from 0.1% by mass to 50% by mass, and more preferably from 0.5% by mass to 10% by mass, with respect to the total mass of the vinyl compound.

Examples of the bi- or poly-functional vinyl compound include compounds obtained by reacting a polyol with an α,β-unsaturated carboxylic acid (for example, polyethylene glycol di(meth)acrylate (with 2 to 14 ethylene groups), ethylene glycol di(meth)acrylate, trimethylolpropane di(meth)acrylate, trimethylolpropane tri(meth)acrylate, trimethylolpropane ethoxy tri(meth)acrylate, trimethylolpropane propoxy tri(meth)acrylate, tetramethylol methane tri(meth)acrylate, tetramethylol methane tetra(meth)acrylate, polypropylene glycol di(meth)acrylate (with 2 to 14 propylene groups), dipentaerythritol penta(meth)acrylate, dipentaerythritol hexa(meth)acrylate, bisphenol A polyoxyethylene di(meth)acrylate, bisphenol A dioxyethylene di(meth)acrylate, bisphenol A trioxyethylene di(meth)acrylate and bisphenol A decaoxyethylene di(meth)acrylate).

Examples of the vinyl compound further include compounds obtained by adding an α,β-unsaturated carboxylic acid to a polyvalent glycidyl group-containing compound (e.g., trimethylolpropane triglycidyl ether triacrylate, bisphenol A diglycidyl ether diacrylate), ester compounds of a polyvalent carboxylic acid (e.g., phthalic anhydride) and a substance having a hydroxy group and an ethylenically unsaturated group (e.g., β-hydroxyethyl(meth)acrylate).

<Radical Polymerization Initiator>

It is preferable to use a radial polymerization initiator in order to polymerize the vinyl compound. The radial polymerization initiator is not particularly limited, and any radial polymerization initiator used for a conventional radical polymerization may be used. Specific examples of a preferred radial polymerization initiator include a peroxide. More specifically, a thermal radical polymerization initiator such as an organic peroxide or an azo radical polymerization initiator, which generates free radicals upon heating, is preferred.

Examples of the organic peroxide include isobutyl peroxide, α,α'-bis(neodecanoylperoxy)diisopropylbenzene, cumyl peroxyneodecanoate, di-n-propyl peroxydicarbonate, di-s-butyl peroxydicarbonate, 1,1,3,3-tetramethylbutyl neodecanoate, bis(4-t-butylcyclohexyl)peroxydicarbonate, 1-cyclohexyl-1-methylethyl peroxyneodecanoate, di-2-ethoxyethyl peroxydicarbonate, di(ethylhexylperoxy)dicarbonate, t-hexyl neodecanoate, dimethoxybutyl peroxydicarbonate, di(3-methyl-3-methoxybutylperoxy)dicarbonate, t-butyl peroxyneodecanoate, t-hexyl peroxypivalate, 3,5,5-trimethylhexanoyl peroxide, octanoyl peroxide, lauroyl peroxide, stearoyl peroxide, 1,1,3,3-tetramethylbutyl peroxy-2-ethylhexanoate, succinic peroxide, 2,5-dimethyl-2,5-di(2-ethylhexanoyl)hexane, 1-cyclohexyl-1-methylethyl peroxy-2-ethylhexanoate, t-hexyl peroxy-2-ethylhexanoate, 4-methylbenzoyl peroxide, t-butyl peroxy-2-ethylhexanoate, m-toluonoylbenzoyl peroxide, benzoyl peroxide, t-butyl peroxyisobutyrate, 1,1-bis(t-butylperoxy)-2-methylcyclohexane, 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane, 1,1-bis(t-butylperoxy)cyclohexanone, 2,2-bis(4,4-dibutylperoxycyclohexyl)propane, 1,1-bis(t-butylperoxy)cyclododecane, t-hexyl peroxyisopropyl monocarbonate, t-butylperoxymaleic acid, t-butyl peroxy-3,5,5-trimethylhexanoate, t-butyl peroxylaurate, 2,5-dimethyl-2,5-di(m-toluoylperoxy)hexane, t-butyl peroxyisopropyl monocarbonate, t-butyl peroxy-2-ethylhexyl monocarbonate, t-hexyl peroxybenzoate, 2,5-dimethyl-2,5-di(benzoylperoxy)hexane, t-butyl peroxyacetate, 2,2-bis(t-butylperoxy)butane, t-butyl peroxybenzoate, n-butyl 4,4-bis(t-butylperoxy)valerate, di-t-butyl peroxyisophthalate, $\alpha,\alpha'$-bis(t-butylperoxy)diisopropylbenzene, dicumyl peroxide, 2,5-dimethyl-2,5-di(t-butylperoxy)hexane, t-butyl cumyl peroxide, di-t-butylperoxy, p-methane hydroperoxide, 2,5-dimethyl-2,5-di(t-butylperoxy)hexyne, diisopropylbenzene hydroperoxide, t-butyltrimethylsilyl peroxide, 1,1,3,3-tetramethylbutyl hydroperoxide, cumene hydroperoxide, t-hexyl hydroperoxide, t-butyl hydroperoxide, and 2,3-dimethyl-2,3-diphenylbutane.

Examples of the azo radical polymerization initiator include azobisisobutyronitrile (AIBN, also known as V-60), 2,2'-azobis(2-methylisobutyronitrile) (also known as V-59), 2,2'-azobis(2,4-dimethyl valeronitrile) (also known as V-65), dimethyl-2,2'-azobis(isobutyrate) (also known as V-601) and 2,2'-azobis(4-methoxy-2,4-dimethyl valeronitrile) (also known as V-70).

The amount of the radical polymerization initiator can be appropriately selected in accordance with the kind of the vinyl compound, the refractive index of the polymer particles to be formed, and the like, and the radical polymerization initiator can be used in a conventional amount. More specifically, the radical polymerization initiator can be used, for example, in an amount of from 0.01% by mass to 2% by mass, and preferably from 0.1% by mass to 1 % by mass, with respect to the vinyl compound.

<Method of Producing Inorganic Phosphor-Containing Polymer Particles>

Examples of the method of producing the inorganic phosphor-containing polymer particles include a method that includes: a process of surface-modifying an inorganic phosphor with a surface treatment agent; a process of preparing a composition including the inorganic phosphor that has been surface-modified, a monomer such as a vinyl compound, and a radical polymerization initiator; and a process of performing radical polymerization of the composition.

Other methods of producing the inorganic phosphor-containing polymer particles include a method in which polymer particles are preliminarily produced by polymerizing a monomer, and an inorganic phosphor is attached or bonded to surfaces of the polymer particles.

Examples of the radical polymerization include emulsion polymerization, suspension polymerization and bulk polymerization. In a case of bulk polymerization, it is preferable to pulverize a bulk polymer obtained in the bulk polymerization. Examples of the pulverization method include a method utilizing a jet mill.

The conditions for the radical polymerization may be that of a conventional radical polymerization. In a case in which a thermal radical polymerization initiator is used as the radical polymerization initiator, radical polymerization is performed by heating. The heating temperature and the heating duration are preferably adjusted in accordance with the kinds of the vinyl compound and the radical polymerization initiator. For example, the heating temperature is in a range of from 30°C to 80°C and the heating duration is in a range of from 1 hour to 10 hours.

In a case of suspension polymerization, a suspension is prepared by adding ion-exchanged water, a surfactant and the like to the above-described composition, and mixing the same and subjecting to radical polymerization. Then, a precipitate is separated from the suspension, washed with ion-exchanged water and dried, whereby inorganic phosphor-containing polymer particles are obtained.

The content of the inorganic phosphor in the inorganic phosphor-containing polymer particles can be appropriately selected in accordance with the intended use of the inorganic phosphor-containing polymer particles, and preferably from 0.001% by mass to 10% by mass, more preferably from 0.01% by mass to 5% by mass, and still more preferably from 0.1 % by mass to 3% by mass.

The content of the inorganic phosphor in the inorganic phosphor-containing polymer particles refers to a value measured by thermal analysis. In the thermal analysis, TG/DTA simultaneous measuring instrument (for example, trade name: DTG-60H, manufactured by Shimadzu Corporation) is used as a thermal analysis instrument. The inorganic phosphor-containing polymer particles (wavelength conversion material) are measured at from 25°C to 700°C with a rate of temperature increase of 10°C/min and an air flux of 50 ml/min. The content of the inorganic phosphor in the inorganic phosphor-containing polymer particles is calculated based on the sample mass of inorganic phosphor-containing polymer particles (wavelength conversion material) measured at an initial stage of the measurement (at 25°C) and the sample mass measured at 700°C.

$$\text{Content of inorganic phosphor in wavelength conversion material} = \text{sample mass (at 700°C)} / \text{sample mass (at 25°C)} \times 100$$

The volume average particle diameter of the inorganic phosphor-containing polymer particles can be appropriately selected in accordance with the intended use of the inorganic phosphor-containing polymer particles. In a case in which the inorganic phosphor-containing polymer particles is used as a wavelength conversion material, the volume average particle diameter of the inorganic phosphor-containing polymer particles is preferably from 1μ m to 1000 μm, more preferably from 5 μm to 300 μm, still more preferably from 10 μm to 200 μm, and yet more preferably from 50 μm to 150 μm, from the viewpoint of improving the light use efficiency.

The ratio of the volume average particle diameter d of the inorganic phosphor to the volume average particle diameter D of the inorganic phosphor-containing polymer particles (d/D) may be appropriately selected in accordance with the intended use of the inorganic phosphor-containing polymer particles, and preferably from 0.005 to 20, more preferably from 0.05 to 10, and still more preferably from 0.5 to 5.

The inorganic phosphor-containing polymer particles can be preferably used as a wavelength conversion material for a photovoltaic cell, and can be used for a photovoltaic cell modules such as a thin-film polycrystalline silicon photovoltaic cell, a thin-film compound-semiconductor photovoltaic cell, or an amorphous silicon photovoltaic cell.

<Photovoltaic cell Module>

Generally, in a silicon photovoltaic cell, light of a wavelength of shorter than 400 nm and light of a wavelength of longer than 1200 nm in sunlight are not effectively utilized, and approximately 56% of the energy from sunlight does not contribute to power generation due to this spectral mismatching. In the invention, the inorganic phosphor having an excellent light resistance is incorporated into polymer particles. By using the inorganic phosphor-containing polymer particles having such a configuration as the wavelength conversion material, scattering of incident sunlight by an inorganic phosphor can be suppressed, incident sunlight can be efficiently introduced into the photovoltaic cell element, and the sunlight is stably utilized, whereby the spectral mismatching is overcome.

The photovoltaic cell module includes essential members such as an antireflection film, a protection glass, a sealing material, a photovoltaic cell element, a back film, a cell electrode and a tabbing wire. Among these members, examples of the light transmissive layer having a light transmission ability include an antireflection film, a protection glass, a sealing material, and layers of SiNx:H or Si of a photovoltaic cell element.

The order of position of the light transmissive layers is typically an antireflection film which is optionally formed, a protection glass, a sealing material, a SiNx:H layer of a photovoltaic cell element, and a Si layer of a photovoltaic cell element, from the light-receiving surface of the photovoltaic cell module.

The inorganic phosphor-containing polymer particles (hereinafter, also referred to as a "wavelength conversion material") may be disposed at any position in a path for light to reach the photovoltaic cell element. More specifically, the photovoltaic cell module includes a photovoltaic cell element and at least one light transmissive layer, and any one of the at least one light transmissive layer disposed at the light-receiving surface side of the photovoltaic cell element includes the inorganic phosphor-containing polymer particles.

Examples of the method for incorporating a wavelength conversion material into the light transmissive layer include a method in which the wavelength conversion material is mixed with a material for a protection glass or a sealing material, and a method in which the wavelength conversion material is combined with an appropriate solvent and applied the mixture to an intended position. Any method can be applied as long as absorption of sunlight by the photovoltaic cell element is not inhibited and the function of the wavelength conversion material is not deteriorated. From the viewpoint of simplifying the production process, a method in which the wavelength conversion material is mixed with a sealing material is advantageous.

In a case in which the wavelength conversion material according to the invention is disposed in the sealing material, in order to effectively introduce external light of any angle of incidence with a minimum loss in reflection, the light transmissive layer that includes a wavelength conversion material (hereinafter, referred to as a "wavelength conversion layer") preferably has a refractive index that is higher than a refractive index of the light transmissive layers that are disposed at the light-entering side of the wavelength conversion layer (e.g., an antireflective film or a protection glass) and lower than a refractive index of the light transmissive layers that are disposed opposite the light-entering side of the wavelength conversion layer (e.g., a SiNx:H layer (also referred to as a "cell antireflective film") or a Si layer of a photovoltaic cell element).

Examples of the sealing material that can be used include an ethylene-vinyl acetate resin. The content of the inorganic phosphor with respect to the sealing material can be appropriately selected in accordance with the kind or the like of the inorganic phosphor, which is preferably from 0.00001% by mass to 1% by mass, more preferably from 0.0001% by mass to 0.1 % by mass, and still more preferably from 0.001 % by mass to 0.01 % by mass.

Examples

Hereinbelow, the present invention is described in more detail with reference to the Examples, but the invention

is not limited to the Examples.

*Example 1-1*

<Surface Modification of Inorganic Phosphor>

5 g of an inorganic phosphor ($BaMg_2Al_{16}O_{27}$:Eu, Mn) with a volume average particle diameter of 3.1 μm was dispersed in 50 g of toluene, and 0.05 g of a silane coupling agent (trade name; SZ6030, manufactured by Dow Corning Toray Co., Ltd.) were added thereto while stirring. The mixture was stirred for 1 hour at room temperature (25°C) and filtered. The obtained solid component was subjected to heat treatment for 1 hour in an explosion-proof oven set at 110°C, thereby obtaining 5.05 g of a surface-modified inorganic phosphor.

<Production of Inorganic Phosphor-containing Polymer Particles>

Each of 0.05 g of the surface-modified inorganic phosphor obtained above, 95 g of methyl methacrylate, 5 g of ethylene glycol dimethacrylate and 0.5 g of 2,2'-azobis(2,4-dimethyl valeronitrile) as a thermal radical polymerization initiator was weighed out and added to a 200-mL screw-capped tube. The resultant was mixed for 1 hour at 100 revolutions per minute with a mixing rotor, thereby preparing a mixture. 500 g of ion-exchanged water and 59.1 g of a 1.69%-by-mass polyvinyl alcohol solution as a surfactant were added to a separable flask equipped with a condenser, and stirred. To this, the preliminarily prepared mixture was added and heated to 50°C to react for 4 hours while stirring at 350 revolutions per minute with a stirring blade, thereby obtaining a suspension liquid.

The volume average particle diameter of the suspension liquid was measured with a laser diffraction scattering particle size distribution analyzer (trade name: LS 13320, manufactured by Beckman Coulter Inc.) at a pump speed of 50%, a refractive index of the inorganic phosphor-containing polymer particles as 1.5 and a refractive index of water as 1. 33. The result was 104 μm. The precipitation was separated and washed with ion-exchanged water, and dried at 60°C. Inorganic phosphor-containing polymer particles (wavelength conversion material) were thus prepared by suspension polymerization.

<Measurement of Fluorescence Excitation Spectrum>

The obtained inorganic phosphor-containing polymer particles were measured for an excitation spectrum at a fluorescence wavelength of 516 nm with a fluorescence spectrophotometer (trade name: F-4500, manufactured by Hitachi, Ltd.) The obtained excitation spectrum is shown in Fig. 1 together with the excitation spectrum obtained in Comparative Example 1-1.

*Comparative Example 1-1*

Comparative inorganic phosphor-containing polymer particles were obtained in the same manner as in the "Production of Inorganic Phosphor-containing Polymers" of Example 1-1, except that an inorganic phosphor without surface modification was used. The "Measurement of Fluorescence Excitation Spectrum" of the obtained inorganic phosphor-containing polymer particles was conducted in the same manner as Example 1-1.

As shown in Fig.1, it was confirmed that a higher emission intensity was exhibited in Example 1-1, in which the inorganic phosphor was surface-modified, compared to Comparative Example 1-1. This is presumed to be because the polymer particles of Example 1-1 contain a greater amount of inorganic phosphor than Comparative Example 1-1.

*Example 2-1*

<Production of Inorganic Phosphor-containing Polymer Particles>

Each of 0.05 g of the surface-modified inorganic phosphor obtained in Example 1-1, 65 g of methyl methacrylate, 5 g of ethylene glycol dimethacrylate, 30 g of dicyclopentanyl methacrylate and 0.5 g of 2,2'-azobis(2,4-dimethyl valeronitrile) as a thermal radical polymerization initiator was weighed out and added to a 200-mL screw-capped tube. The resultant was mixed for 1 hour at 100 revolutions per minute with a mixing rotor, thereby preparing a mixture. 500 g of ion-exchanged water and 59.1 g of a 1.69%-by-mass polyvinyl alcohol solution as a surfactant were added to a separable flask equipped with a condenser, and the resultant was stirred. To this, the preliminarily prepared mixture was added, and the resultant was heated to 50°C to react for 4 hours while stirring at 350 revolutions per minute with a stirring blade, thereby obtaining a suspension liquid.

The volume average particle diameter of the resultant suspension liquid was measured with a laser diffraction

scattering particle size distribution analyzer (trade name: LS 13320, manufactured by Beckman Coulter Inc.) at a pump speed of 50%, a refractive index of the inorganic phosphor-containing polymer particles of 1.5 and a refractive index of water of 1.33. The result was 104 μm. The precipitation was separated and washed with ion-exchanged water, and dried at 60°C. Inorganic phosphor-containing polymer particles (wavelength conversion material) were thus prepared by suspension polymerization.

<Measurement of Fluorescence Excitation Spectrum>

The obtained inorganic phosphor-containing polymer particles were measured for an excitation spectrum in the same manner as in Example 1-1. The obtained excitation spectrum is shown in Fig. 2 together with the results obtained in Examples 2-2 and 2-3.

<Measurement of number of Inorganic Phosphor-containing Polymer Particles>

The obtained inorganic phosphor-containing polymer particles were exposed to light of a wavelength of 365 nm with a handy UV lamp (trade name: SLUV-4, manufactured by AS ONE Corporation), and the number of inorganic phosphor-containing polymer particles that emit light was determined with a microscope. The result of the observation of 100 inorganic-containing polymer particles is shown in Table 1.

*Example 2-2*

Inorganic phosphor-containing polymer particles were obtained in the same manner as in the "Production of Inorganic Phosphor-containing Polymer Particles" of Example 2-1, except that 30 g of dicyclopentenyl acrylate were added instead of dicyclopentanyl methacrylate. The "Measurement of Fluorescence Excitation Spectrum" and the " Measurement of Number of Inorganic Phosphor-containing Polymer Particles" of the obtained inorganic phosphor-containing polymer particles were conducted in the same manner as in Example 2-1.

*Example 2-3*

Inorganic phosphor-containing polymer particles were obtained in the same manner as in the "Production of Inorganic Phosphor-containing Polymer Particles" of Example 2-1, except that the amount of methyl methacrylate was changed to 95 g, and that dicyclopentanyl acrylate was not added. The "Measurement of Fluorescence Excitation Spectrum" and the " Measurement of Number of Inorganic Phosphor-containing Polymer Particles" of the obtained inorganic phosphor-containing polymer particles were conducted in the same manner as in Example 2-1.

Table 1

| | Number of particles that emit light (number/100 particles) |
|---|---|
| Example 2-2 | 95 |
| Example 2-2 | 100 |
| Example 2-3 | 20 |

As shown in Fig.2, it was confirmed that a higher emission intensity was exhibited in Examples 2-1 and 2-2, in which a compound having a structure represented by at least one of Formula (I-1) or (I-2) as the vinyl compound, as compared to Example 2-3. Furthermore, as shown in Table 1, it was confirmed that the number of the inorganic phosphor-containing polymer particles was greater in Examples 2-1 and 2-2 than in Example 2-3. It is presumed that the emission intensity of Examples 2-1 and 2-2 was higher because the amount of the inorganic phosphor contained in the inorganic phosphor-containing polymer particles was greater than Example 2-3.

*Example 3-1*

<Production of Inorganic Phosphor-containing Polymer Particles>

Each of 0.05 g of the surface-modified inorganic phosphor obtained in Example 1-1, 95 g of methyl methacrylate, 5 g of ethylene glycol dimethacrylate and 0.5 g of 2,2'-azobis(2,4-dimethyl valeronitrile) as a thermal radical polymerization initiator was weighed out and added to a 200-mL screw-capped tube. The resultant was mixed for 1 hour at 100 revolutions

per minute with a mixing rotor, thereby preparing a mixture. 500 g of ion-exchanged water and 59.1 g of a 1.69%-by-mass polyvinyl alcohol solution as a surfactant were added to a separable flask equipped with a condenser, and stirred. To this, the preliminarily prepared mixture was added, and the resultant was heated to 50°C to react for 4 hours while stirring at 350 revolutions per minute with a stirring blade, thereby obtaining a suspension liquid.

The volume average particle diameter of the resultant suspension liquid was measured with a laser diffraction scattering particle size distribution analyzer (trade name: LS 13320, manufactured by Beckman Coulter Inc.) at a pump speed of 50%, a refractive index of the inorganic phosphor-containing polymer particles of 1.5 and a refractive index of water of 1.33. The result was 104 μm. The precipitation was separated and washed with ion-exchanged water, and dried at 60°C. Inorganic phosphor-containing polymer particles (wavelength conversion material) were thus obtained by suspension polymerization.

<Light Resistance Test>

The wavelength conversion material was exposed to light at an irradiance of 180 W/$m^2$ (wavelength of radiation light: 300 nm to 400 nm) with a 7.5-kW super xenon weather meter (trade name: SX75, manufactured by Suga Test Instruments Co., Ltd.) as a light-resistance tester. The wavelength conversion material was exposed to light of a wavelength of 365 nm with a handy UV lamp (trade name: SLUV-4, manufactured by AS ONE Corporation.) before the test and after the test (after 72 hours), respectively, and the presence or absence of light emission was observed.

<Preparation of Resin Composition>

A resin composition was prepared by mixing 100 g of ethylene-vinyl acetate resin (trade name: ULTRATHENE 634 ("ULTRATHENE" is a registered trademark), manufactured by Tosoh Corporation) as a transparent material (sealing material), 1.5 g of LUPEROX 101 ("LUPEROX" is a registered trademark, manufactured by ARKEMA Yoshitomi, Ltd.) as a peroxide thermal radical polymerization initiator, 0.5 g of a silane coupling agent (trade name: SZ6030, manufactured by Dow Corning Toray Co., Ltd.) and 1.0 g of the wavelength conversion material prepared above and kneading the mixture with a roll mixer adjusted to 100°C.

<Production of Wavelength Conversion Sealing Sheet>

The above-obtained resin composition was placed between releasing sheets in an amount of approximately 30 g, and processed into a sheet with a pressing machine with a hot plate temperature of 80°C and stainless spacers having a thickness of 0.6 mm. A wavelength conversion sealing sheet was thus obtained.

<Production of Sealing Sheet for Back Surface>

A resin composition for a back surface was prepared in the same manner as the "Preparation of Resin Composition" described above, except that the wavelength conversion material was not added. A sealing sheet for a back surface was produced in the same manner as the production of the wavelength conversion sealing sheet above, except that the resin composition for a back surface was used.

<Production of Wavelength Conversion-type Photovoltaic Cell Module>

The wavelength conversion sealing sheet was disposed on a tempered glass (manufactured by Asahi Glass Co., Ltd.) as a protection glass, and a photovoltaic cell element (trade name: SC156R200K1820, manufactured by FerroTec China) configured to provide an electromotive force to the exterior was disposed thereon, such that the light-receiving surface thereof faced downward. Then, the sealing sheet for a back surface and a polyethylene terephthalate (PET) film (trade name: A-4300, manufactured by Toyobo Co., Ltd.) as a back film were disposed thereon, and the resultant was subjected to a lamination process with a vacuum pressure laminator under the conditions of a hot plate temperature of 150°C, a vacuum time of 10 minutes and a pressure time of 15 minutes. A wavelength conversion-type photovoltaic cell module was thus obtained.

<Evaluation of Properties of Photovoltaic cell>

A solar simulator (trade name: WXS-155S-10, AM1.5G, manufactured by Wacom Electric Co., Ltd.) was used as a simulated solar radiation, and the short-circuit current density Jsc (cell) of the photovoltaic cell element before sealing the module and the short-circuit current density Jsc (module) after sealing the module were measured with an I-V curve tracer (trade name: MP-160, manufactured by EKO Instruments Co., Ltd.), respectively. The difference in the

measured values ($\Delta Jsc$ = Jsc (module) - Jsc (cell)) was calculated for evaluating the current-voltage characteristics. As a result, the value of $\Delta Jsc$ was 0.5 $mA/cm^2$.

<Production of Evaluation Sample>

The wavelength conversion sealing sheet obtained above was disposed on a glass plate, and another glass plate was disposed thereon. The resultant was laminated with a vacuum pressure laminator for photovoltaic cell (trade name: LM-50×50-S, manufactured by NPC Inc.) under the conditions of a hot plate temperature of 150°C, a vacuum time of 10 minutes and a pressure time of 15 minutes, thereby producing an evaluation sample.

<Measurement of Haze of Evaluation Sample>

The haze (haze value) of the evaluation sample obtained above was measured with a turbidity meter (trade name: NDH5000, manufactured by Nippon Denshoku Industries, Co., Ltd.) in accordance with JIS K 7105. The result was 0.6%.

*Comparative Example 3-1*

The light resistance of the wavelength conversion material was evaluated in the same manner as Example 3-1, except that a rare-earth complex $Eu(TTA)_3$ Phen was used as a phosphor instead of the surface-modified inorganic phosphor used in the "Preparation of Inorganic Phosphor-containing Polymer Particles".

*Comparative Example 3-2*

The "Evaluation of Properties of Photovoltaic cell" and the "Measurement of Haze of Evaluation Sample" were conducted in the same manner as above, except that 0.0005 g of an inorganic phosphor ($BaMg_2Al_{16}O_{27}$:Eu, Mn) without surface modification were used instead of 1.0 g of the wave-length conversion material used in the "Preparation of Resin Composition" in Example 3-1.

*Comparative Example 3-3*

The "Evaluation of Properties of Photovoltaic cell" and the "Measurement of Haze of Evaluation Sample" were conducted in the same manner as above, except that 0.05 g of an inorganic phosphor ($BaMg_2Al_{16}O_{27}$:Eu, Mn) without surface modification was used instead of 1.0 g of the wave-length conversion material used in the "Preparation of Resin Composition" in Example 3-1.

Table 2

| | Concentration of inorganic phosphor with respect to transparent material (% by mass) | Light emission | |
|---|---|---|---|
| | | Before test (0 hr) | Light resistance test (after 72 hrs) |
| Example 3-1 | 0.05 | Present | Present |
| Comparative Example 3-1 | 0.05 | Present | Absent |

Table 3

| | Concentration of inorganic phosphor with respect to sealing material (% by mass) | $\Delta Jsc$ ($mA/cm^2$) | Haze |
|---|---|---|---|
| Example 3-1 | 0.0005 | 0.05 | 0.60 |
| Comparative Example 3-2 | 0.0005 | 0.2 | 1.00 |
| Comparative Example 3-3 | 0.05 | -0.1 | 4.26 |

As shown in Table 2, it was confirmed that the wavelength conversion material including the inorganic phosphor

exhibited a higher light resistance as compared to the wavelength conversion material including the rare-earth complex. Furthermore, as shown in Table 3, it was confirmed that in the sealing sheet in which the polymer particles, in which the inorganic phosphor is included in the transparent material, were dispersed, the haze was suppressed and a higher module effect was obtained as compared to the sheet in which the inorganic phosphor is directly dispersed.

*Example 4-1*

<Surface Modification of Inorganic Phosphor>

5 g of an inorganic phosphor ($BaMg_2Al_{16}O_{27}$:Eu, Mn) with a volume average particle diameter of 2.3 μm and a density of 3.8 g/cm$^3$ were dispersed in 50 g of toluene, and 0.05 g of a silane coupling agent (trade name: SZ6030, 3-methacryloyloxypropyltrimethoxysilane, manufactured by Dow Corning Toray Co., Ltd.) were added thereto while stirring. The mixture was stirred for 1 hour at room temperature (25°C) and then filtered. The obtained solid component was subjected to heat treatment for 1 hour in an oven set at 110°C, thereby obtaining a surface-modified inorganic phosphor.

<Production of Inorganic Phosphor-containing Polymer Particles>

Each of 0.43 g of the surface-modified inorganic phosphor ($BaMg_2Al_{16}O_{27}$:Eu, Mn) obtained above, 27.86 g of methyl methacrylate (viscosity at 25°C: 0.44 mPa·s), 12.86 g of dicyclopentenyl acrylate (viscosity at 25°C: 10.63 mPa·s, trade name: FA-511AS, manufactured by Hitachi Chemical Company, Ltd.), 2.14 g of ethylene glycol dimethacrylate (viscosity at 25°C: 2.98 mPa·s, trade name: FA-121M, manufactured by Hitachi Chemical Company, Ltd.) and 0.21g of 2,2'-azobis(2,4-dimethyl valeronitrile) as a thermal radical polymerization initiator was weighed out and added to a screw-capped tube. The resultant was mixed for 1 hour at 100 revolutions per minute with a mixing rotor, thereby preparing a mixed solution.

The obtained mixed solution was added to 300 g of pure water in which 0.43 g of polyvinyl alcohol (K-type GOHSENOL KH-20, manufactured by The Nippon Synthetic Chemical Industry Co., Ltd) were dissolved while stirring at 350 revolutions per minute with a stirring blade. The resultant was subjected to nitrogen bubbling at room temperature (25°C), and heated to 50°C in a nitrogen stream and polymerized for 4 hours at the same temperature. The resultant was further heated to 80°C to remove the remaining radical polymerization initiator and stirred for 2 hours to complete the reaction. The resultant was cooled to room temperature (25°C), and the product was separated and washed sufficiently with purified water, and dried at 60°C. Inorganic phosphor-containing polymer particles (wavelength conversion material) were thus obtained.

<Light Resistance Test>

The light resistance test for the wavelength conversion material was performed in the same manner as Example 3-1.

<Thermal Analysis>

The measurement was conducted with a TG/DTA simultaneous measuring instrument (trade name: DTG-60H, manufactured by Shimadzu Corporation) as a thermal analysis instrument at from room temperature (25°C) to 700°C at a rate of a temperature increase of 10°C/min and an air flux of 50ml/min.

The content of the inorganic phosphor in the wavelength conversion material (content of inorganic phosphor in wavelength conversion material = sample mass (at 700°C)/ sample mass (at 25°C) × 100) was evaluated based on the sample mass of inorganic phosphor-containing polymer particles (wavelength conversion material) at an initial stage of the measurement and the sample mass at 700°C.

<Measurement of Fluorescence Excitation Spectrum>

The obtained inorganic phosphor-containing polymer particles were measured for an excitation spectrum in the same manner as Example 1-1. The excitation spectrum of the obtained wavelength conversion material is shown in Fig. 3 together with the excitation spectrum of the wavelength conversion material obtained in Example 4-2.

<Preparation of Resin Composition>

A resin composition was prepared by mixing 100 g an ethylene-vinyl acetate resin (trade name: ULTRATHENE

634 ("ULTRATHENE" is a registered trademark), manufactured by Tosoh Corporation) as a transparent material (sealing material), 1.5 g of LUPEROX 101 (2,5-dimethyl-2,5-di(t-butylperoxy)hexane) ("LUPEROX" is a registered trademark, manufactured by ARKEMA Yoshitomi, Ltd.) as an organic peroxide-based thermal radical polymerization initiator, 0.5 g of a silane coupling agent (3-methacryloxypropyltrimethoxysilane, trade name: SZ6030, manufactured by Dow Corning Toray Co., Ltd.) and 1.0 g of the wavelength conversion material obtained above and kneading the mixture with a roll mixer at 100°C.

<Production of Wavelength Conversion Sealing Sheet>

The resin composition was disposed between releasing sheets at an amount of approximately 30 g and processed into a sheet with a pressing machine at a hot plate temperature of 80°C and stainless spacers having a thickness of 0.6 mm, thereby obtaining a wavelength conversion sealing sheet.

<Production of Sealing Sheet for Back Surface>

A resin composition for a back surface was prepared in the same manner as the "Preparation of Resin Composition" described above, except that the wavelength conversion material was not used. A sealing sheet for a back surface was produced in the same manner as the production of the wavelength conversion sealing sheet described above, except that the resin composition for a back surface was used.

<Production of Wavelength Conversion-type Photovoltaic Cell Module>

The wavelength conversion sealing sheet obtained above was disposed on a tempered glass for a photovoltaic cell (manufactured by Asahi Glass Co., Ltd.) as a protection glass, and a photovoltaic cell element configured to provide an electromotive force to the exterior was disposed thereon such that the light-receiving surface thereof faced downward. Then, the sealing sheet for a back surface and a PET film (trade name: A-4300, manufactured by Toyobo Co., Ltd.) as a back film were disposed thereon and the resultant was laminated with a vacuum pressure laminator under the conditions of a hot plate temperature of 150°C, a vacuum time of 10 minutes and a pressure time of 15 minutes. A wavelength conversion-type photovoltaic cell module was thus obtained.

<Evaluation of Properties of Photovoltaic Cell>

The wavelength conversion-type photovoltaic cell module was evaluated for the properties of the photovoltaic cell in the same manner as Example 3-1. As a result, the value of $\Delta$Jsc was 0.5 mA/cm$^2$.

*Comparative Example 4-1*

The light resistance of the wavelength conversion material was evaluated in the same manner as Example 4-1, except that a rare-earth complex Eu(TTA)$_3$Phen [(1,10-phenanthroline)tris[4,4,4-trifluoro-1-(2-thienyl)-1,3-butanedionato]europium(III)] was used as a phosphor instead of the surface-modified inorganic phosphor used in the "Production of Inorganic Phosphor-containing Polymer Particles" in Example 4-1.

*Comparative Example 4-2*

The "Light Resistance Test", the "Thermal Analysis", the "Measurement of Fluorescence Excitation Spectrum" and the "Evaluation of Properties of Photovoltaic cell" were conducted in the same manner as Example 4-1, except that 40.29 g of methyl methacrylate (viscosity at 25°C: 0.44 mPa·s), 0.42 g of pentamethyl piperidyl methacrylate (viscosity at 25°C: 10.80 mPa·s, trade name: FA-711MM, manufactured by Hitachi Chemical Company, Ltd.) and 2.14 g of ethylene glycol dimethacrylate (viscosity at 25°C: 2.98 mPa·s, trade name: FA-121M, manufactured by Hitachi Chemical Company, Ltd.) were used instead of 27.86 g of methyl methacrylate (viscosity at 25°C: 0.44 mPa·s), 12.86 g of dicyclopentenyl acrylate (viscosity at 25°C: 10.63 mPa·s, trade name: FA-51 IAS, manufactured by Hitachi Chemical Company, Ltd.) and 2.14 g of ethylene glycol dimethacrylate (viscosity at 25°C: 2.98 mPa·s, trade name: FA-121M, manufactured by Hitachi Chemical Company, Ltd.) that were used in the "Production of Inorganic Phosphor-containing Polymer Particles".

Table 4

| | Light emission | |
|---|---|---|
| | Before test (0 hr) | Light resistance test (after 72 hrs) |
| Example 4-1 | Present | Present |
| Comparative Example 4-1 | Present | Absent |
| Example 4-2 | Present | Absent |

Table 5

| | Content of vinyl compound with 5 to 30 Pa·s (% by mass)*1 | Concentration of inorganic phosphor with respect to transparent material (% by mass) | Concentration of inorganic phosphor in wavelength conversion material (% by mass) | ΔJsc ($mA/cm^2$) |
|---|---|---|---|---|
| Example 4-1 | 30 | 1 | 0.68 | 0.50 |
| Example 4-2 | 1 | 1 | 0.41 | 0.23 |
| *1: The total amount of the vinyl compound was set to be 100 parts by mass. | | | | |

As shown in Table 4, it was confirmed that the wavelength conversion material including the inorganic phosphor exhibited a higher light resistance as compared to the wavelength conversion material including the rare-earth complex. Furthermore, as shown in Table 5, it was confirmed that the amount of the inorganic phosphor incorporated in the transparent material by suspension polymerization was increased and a higher module effect was obtained when the content of a vinyl compound having a viscosity of from 5 Pa·s to 30 Pa·s in the total vinyl compound was 10% by mass or more.

*Example 5-1*

<Surface Modification of Inorganic Phosphor ($Y_2O_2S$:Eu)>

5 g of an inorganic phosphor ($Y_2O_2S$:Eu) with a volume average particle diameter of 1.8 μm and a specific gravity of 5.1 were dispersed in 50 g of toluene, and 0.05 g of a silicone oligomer having an acryloyl group as a reactive group (trade name: KR-513, manufactured by Shin-Etsu Chemical Co., Ltd.) as a surface treatment agent were added thereto while stirring. The mixture was stirred for 1 hour at room temperature (25°C) and separated. The obtained solid component was subjected to heat treatment for 1 hour in an oven at 110°C, thereby obtaining a surface-modified inorganic phosphor.

<Production of Inorganic Phosphor-containing Polymer Particles>

Each of 0.43 g of the surface-modified inorganic phosphor ($Y_2O_2S$:Eu) obtained above, 27.86 g of methyl methacrylate, 12.86 g of dicyclopentenyl acrylate (trade name: FA-511AS, manufactured by Hitachi Chemical Company, Ltd.), 2.14 g of ethylene glycol dimethacrylate (trade name: FA-121M, manufactured by Hitachi Chemical Company, Ltd.) and 0.21g of 2,2'-azobis(2,4-dimethyl valeronitrile) as a thermal radical polymerization initiator was weighed out and added to a screw-capped tube. The resultant was mixed for 1 hour at 100 revolutions per minute with a mixing rotor, thereby preparing a mixed solution.

The obtained mixed solution was added to 300 g of pure water in which 0.43 g of polyvinyl alcohol (K-type GOHSENOL KH-20, manufactured by The Nippon Synthetic Chemical Industry Co., Ltd) were dissolved while stirring at 350 revolutions per minute with a stirring blade. The resultant was subjected to nitrogen bubbling at room temperature (25°C), and then heated to 50°C in a nitrogen stream and polymerized for 4 hours at the same temperature. The resultant was further heated to 80°C to remove the remaining radical polymerization initiator, and stirred for 2 hours to complete the reaction. The resultant was cooled to room temperature (25°C), and the product was separated and washed sufficiently with purified water, and dried at 60°C. Inorganic phosphor-containing polymer particles (wavelength conversion material) were thus obtained.

<Measurement of Fluorescence Excitation Spectrum>

The obtained inorganic phosphor-containing polymer particles were measured for an excitation spectrum, at a fluorescence wavelength of 626 nm when $Y_2O_2S$:Eu was used as the inorganic phosphor or at a fluorescence wavelength of 624 nm when $La_2O_2S$:Eu was used as the inorganic phosphor, with a fluorescence spectrophotometer (trade name: F-4500, Manufactured by Hitachi, Ltd.)

The excitation spectra of the wavelength conversion materials obtained in Examples 5-1, 5-3 and 5-4 are shown in Fig. 4, and the excitation spectra of the wavelength conversion materials obtained in Examples 5-2 and 5-5 are shown in Fig. 5.

<Light Resistance Test>

The light resistance test for the wavelength conversion material was performed in the same manner as Example 3-1.

<Thermal Analysis>

The concentration of the inorganic phosphor in the wavelength conversion material (concentration of inorganic phosphor in wavelength conversion material = sample mass (at 700°C) / sample mass (at 25°C) × 100) was evaluated in the same manner as Example 4-1.

<Preparation of Resin Composition>

A resin composition was prepared by mixing 100 g of ethylene-vinyl acetate resin (trade name: ULTRATHENE 634 ("ULTRATHENE" is a registered trademark), manufactured by Tosoh Corporation) as a transparent material (sealing material), 1.5 g of LUPEROX 101 (2,5-dimethyl-2,5-di(t-butylperoxy)hexane, "LUPEROX" is a registered trademark, manufactured by ARKEMA Yoshitomi, Ltd.) as an organic peroxide thermal radical polymerization initiator, 0.5 g of a silane coupling agent (3-methacryloxypropyltrimethoxysilane, trade name: SZ6030, manufactured by Dow Corning Toray Co., Ltd.) and 1.0 g of the wavelength conversion material obtained above and kneading the mixture with a roll mixer at 100°C.

<Production of Wavelength Conversion Sealing Sheet>

The resin composition obtained above was disposed between releasing sheets in an amount of approximately 30 g, and processed into a sheet with a pressing machine with a hot plate temperature of 80°C and stainless spacers having a thickness of 0.6 mm, thereby obtaining a wavelength conversion sealing sheet.

<Production of Sealing Sheet for Back Surface>

A resin composition for a back surface was prepared in the same manner as the "Preparation of Resin Composition" described above, except that the wavelength conversion material was not used. A sealing sheet for a back surface was produced in the same manner as the production of the wavelength conversion sealing sheet described above, except that the resin composition for a back surface was used.

<Production of Wavelength Conversion-type Photovoltaic Cell Module>

The wavelength conversion sealing sheet obtained above was disposed on a tempered glass for a photovoltaic cell (manufactured by Asahi Glass Co., Ltd.) as a protection glass, and a photovoltaic cell element configured to provide an electromotive force to the exterior was disposed thereon such that the light-receiving surface thereof faced downward. Then, the sealing sheet for a back surface and a PET film (trade name: A-4300, manufactured by Toyobo Co., Ltd.) as a back film were disposed thereon, and the resultant was laminated with a vacuum pressure laminator under the conditions of a hot plate temperature of 150°C, a vacuum time of 10 minutes and a pressure time of 15 minutes, thereby producing a wavelength conversion-type photovoltaic cell module.

<Evaluation of Properties of Photovoltaic Cell>

The wavelength conversion-type photovoltaic cell module was evaluated for the properties of the photovoltaic cell in the same manner as Example 3-1. As a result, the value of ΔJsc was 0.5 $mA/cm^2$.

<Production of Evaluation Sample>

An evaluation sample was produced in the same manner as Example 3-1, except that the wavelength conversion sealing sheet obtained above was used.

*Measurement of Haze of Evaluation Sample*

The haze of the evaluation sample was measured in the same manner as Example 3-1, and the result was 0.6%.

*Example 5-2*

A wavelength conversion material was produced and evaluated in the same manner as Example 5-1, except that $La_2O_2S$:Eu was used as an inorganic phosphor in the "Surface Modification of Inorganic Phosphor ($Y_2O_2S$:Eu)".

Comparative *Example 5-1*

The light resistance of the wavelength conversion material was evaluated in the same manner as Example 5-1, except that a rare-earth complex $Eu(TTA)_3Phen$ [(1,10-phenanthroline)tris[4,4,4-trifluoro-1-(2-thienyl)-1,3-butanedionato]europium(III)] was used as a phosphor instead of the surface-modified inorganic phosphor used in the "Surface Modification of Inorganic Phosphor ($Y_2O_2S$:Eu)" of Example 5-1.

*Example 5-3*

The wavelength conversion material was produced in the same manner as Example 5-1, except that 3-methacryloxypropyltrimethoxysilane (trade name; SZ6030, manufactured by Dow Corning Toray Co., Ltd.) was used as a surface treatment agent in the "Surface Modification of Inorganic Phosphor ($Y_2O_2S$:Eu)", and the evaluations were performed in the same manner.

Table 6

| | Light emission | |
|---|---|---|
| | Before test (0 hr) | Light resistance test (after 72hrs) |
| Example 5-1 | Present | Present |
| Example 5-2 | Present | Present |
| Comparative Example 5-1 | Present | Absent |

Table 7

| | Concentration of inorganic phosphor with respect to transparent material (% by mass) | Concentration of inorganic phosphor in wavelength conversion material (% by mass) |
|---|---|---|
| Example 5-1 | 1.0 | 0.52 |
| Example 5-2 | 1.0 | 0.38 |
| Example 5-3 | 1.0 | 0.09 |

Table 8

| | ΔJsc ($mA/cm^2$) | Haze |
|---|---|---|
| Example 5-1 | 0.5 | 0.60 |
| Example 5-2 | 0.6 | 0.55 |

(continued)

| | ΔJsc ($mA/cm^2$) | Haze |
|---|---|---|
| Example 5-3 | 0.1 | 0.88 |

As shown in Table 6, it was confirmed that the wavelength conversion material including an inorganic phosphor exhibited a higher light resistance as compared to the wavelength conversion material including a rare-earth complex. Furthermore, in the wavelength conversion material obtained by performing suspension polymerization of an inorganic phosphor that was surface-modified with a silicone oligomer having a reactive group, it was confirmed that the amount of the inorganic phosphor incorporated in the polymer particles was increased, as shown in Table 7. In addition, the emission intensity was improved as shown in Figs. 4 and 5, and a higher module effect was obtained and the haze (haze value) as an indicator of scattering was low, as shown in Table 8.

The disclosures of Japanese Patent Application Nos. 2012-063499, 2012-063500, 2012-174900, 2012-174903 and 2012-182280 are incorporated herein by reference in their entireties.

All publications, patent applications, and technical standards mentioned in this specification are herein incorporated by reference to the same extent as if each individual publication, patent application, or technical standard was specifically and individually indicated to be incorporated by reference.

## Claims

1. Inorganic phosphor-containing polymer particles, the particles comprising:

    an inorganic phosphor that is surface-modified with a surface treatment agent; and
    a transparent material.

2. The inorganic phosphor-containing polymer particles according to claim 1, wherein the surface treatment agent is a coupling agent.

3. The inorganic phosphor-containing polymer particles according to claim 2, wherein the coupling agent is at least one selected from the group consisting of a silane coupling agent, a titanate coupling agent and an aluminate coupling agent.

4. The inorganic phosphor-containing polymer particles according to claim 1, wherein the surface treatment agent comprises a silicone oligomer having a reactive substituent.

5. The inorganic phosphor-containing polymer particles according to any one of claim 1 to claim 4, wherein the transparent material comprises a vinyl resin that is a polymer of a vinyl compound.

6. The inorganic phosphor-containing polymer particles according to claim 5, wherein the transparent vinyl resin comprises a (meth)acrylic resin.

7. The inorganic phosphor-containing polymer particles according to claim 5 or claim 6, wherein the vinyl compound comprises a vinyl compound having a viscosity (at 25°C) of from 5 mPa·s to 30 mPa·s in an amount of 10% by mass or more with respect to a total mass of the vinyl compound.

8. The inorganic phosphor-containing polymer particles according to any one of claim 5 to claim 7, wherein the vinyl compound comprises a (meth)acrylic acid derivative having an alicyclic structure.

9. The inorganic phosphor-containing polymer particles according to any one of claim 5 to claim 8, wherein the vinyl compound comprises at least one of a compound having a structure represented by following Formula (I-1) or a compound having a structure represented by following Formula (I-2):

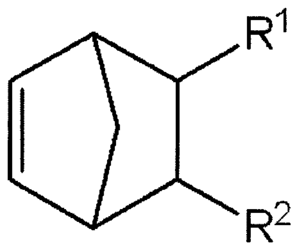

(I-1)

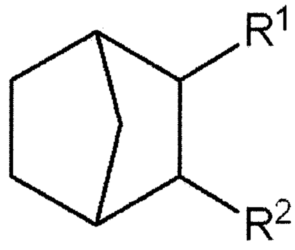

(I-2)

wherein, in Formula (I-1) and Formula (I-2), each of $R^1$ and $R^2$ independently represents a hydrogen atom or an alkyl group, and $R^1$ and $R^2$ may be linked to each other to form a ring.

**10.** The inorganic phosphor-containing polymer particles according to claim 9, wherein the vinyl compound comprises at least one of a compound having a structure represented by following Formula (1) or a compound having a structure represented by following Formula (2):

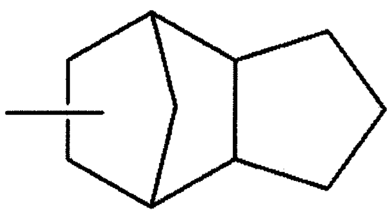

(1)

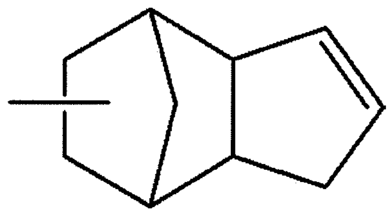

(2)

**11.** The inorganic phosphor-containing polymer particle according to claim 9 or claim 10, wherein the vinyl compound comprises at least one selected from (meth)acrylyate compounds represented by following Formula (II):

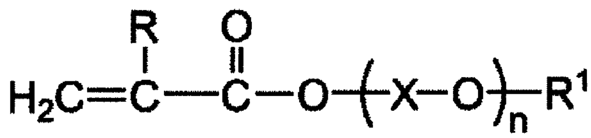

(II)

wherein, in Formula (II), R represents a hydrogen atom or a methyl group; X represents an alkylene group having 1 to 5 carbon atoms; $R^1$ represents following Formula (1) or Formula (2); and n represents an integer from 0 to 10:

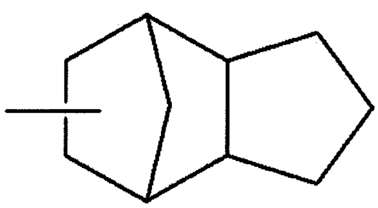

(1)

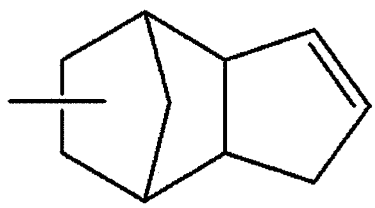

(2)

**12.** The inorganic phosphor-containing polymer particles according to any one of claim 5 to claim 11, wherein the vinyl compound comprises a bi- or poly-functional vinyl compound.

**13.** The inorganic phosphor-containing polymer particles according to any one of claim 5 to claim 12, the particles being an emulsion polymer or a suspension polymer, of a composition comprising the inorganic phosphor and the vinyl compound.

**14.** The inorganic phosphor-containing polymer particles according to any one of claim 5 to claim 12, the particles being a pulverized product of a bulk polymer of a composition comprising the inorganic phosphor and the vinyl compound.

**15.** The inorganic phosphor-containing polymer particles according to any one of claim 1 to claim 14, wherein a content of the inorganic phosphor is from 0.001% by mass to 10% by mass.

**16.** The inorganic phosphor-containing polymer particles according to any one of claim 1 to claim 15, the particles having a volume average particle diameter of from 1 μm to 1000 μm.

**17.** The inorganic phosphor-containing polymer particles according to any one of claim 1 to claim 16, which are a wavelength conversion material for a photovoltaic cell.

**18.** A method of producing the inorganic phosphor-containing polymer particles according to any one of claim 5 to claim 17, the method comprising:

a process of surface-modifying an inorganic phosphor with a surface treatment agent;
a process of preparing a composition comprising the inorganic phosphor that has been surface-modified, a vinyl compound, and a radical polymerization initiator; and
a process of performing radical polymerization of the composition.

**19.** The method of producing the inorganic phosphor-containing polymer particles according to claim 18, wherein the radical polymerization is suspension polymerization in which inorganic phosphor-containing polymer particles having a volume average particle diameter of from 10 μm to 200 μm are synthesized.

**20.** A photovoltaic cell module that comprises a photovoltaic cell element and at least one light transmissive layer, wherein any one of the at least one light transmissive layer disposed on a light-receiving surface side of the photovoltaic cell element comprises the inorganic phosphor-containing polymer particles according to any one of claim 1 to claim 17.

Fig. 1

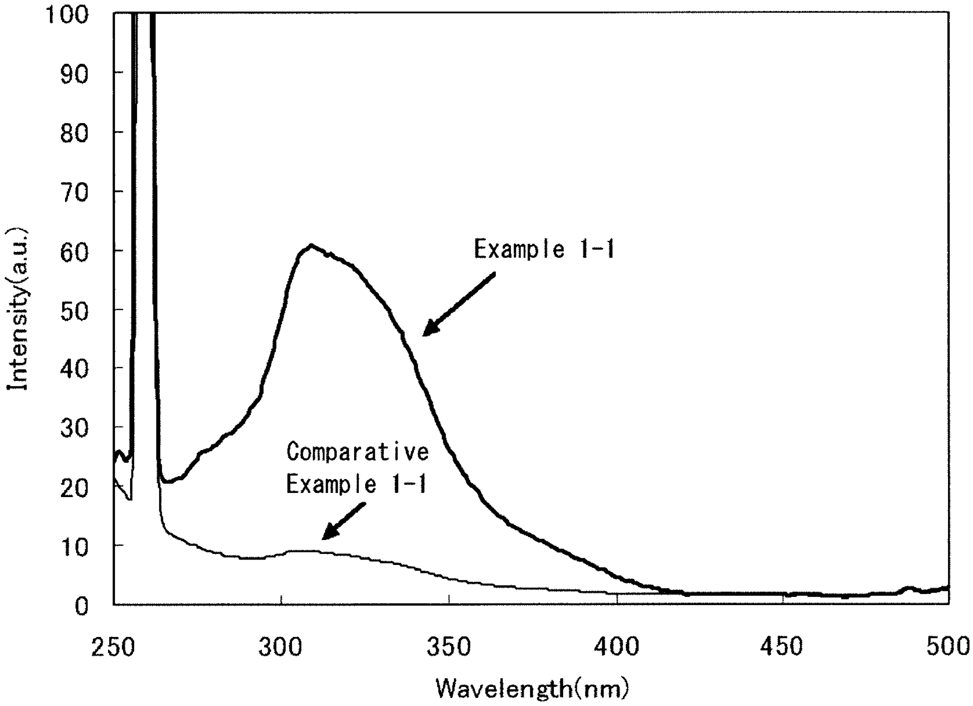
100
90
80
70
60
50
40
30
20
10
0
Intensity(a.u.)
250
300
350
400
450
500
Wavelength(nm)
Example 1-1
Comparative
Example 1-1

Fig. 2

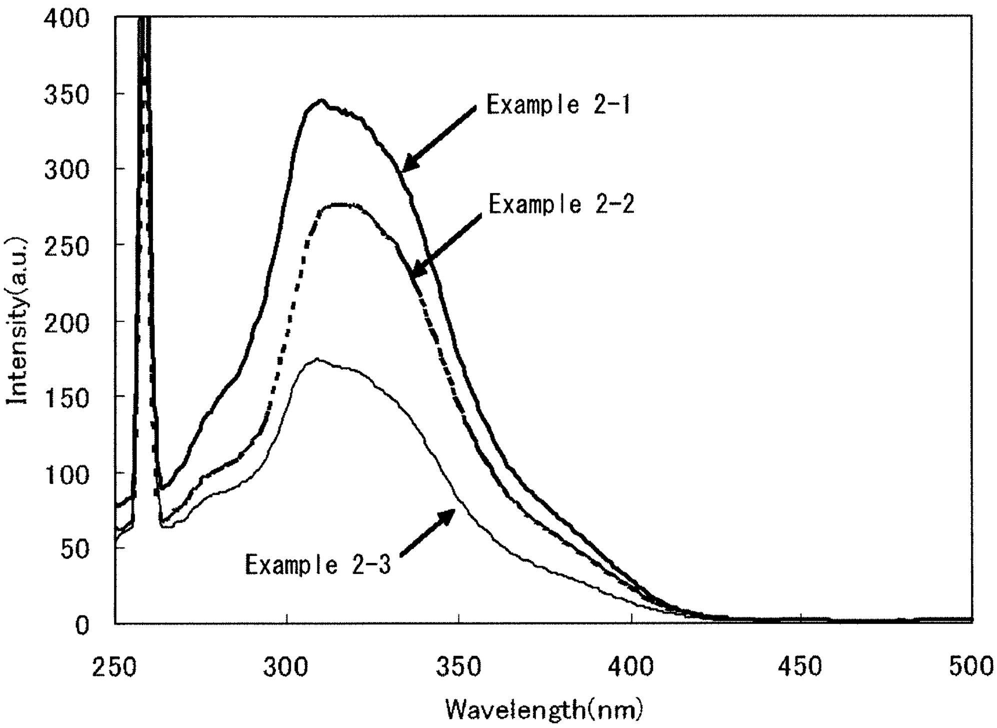
400
350
300
250
200
150
100
50
0
Intensity(a.u.)
250
300
350
400
450
500
Wavelength(nm)
Example 2-1
Example 2-2
Example 2-3

Fig. 3

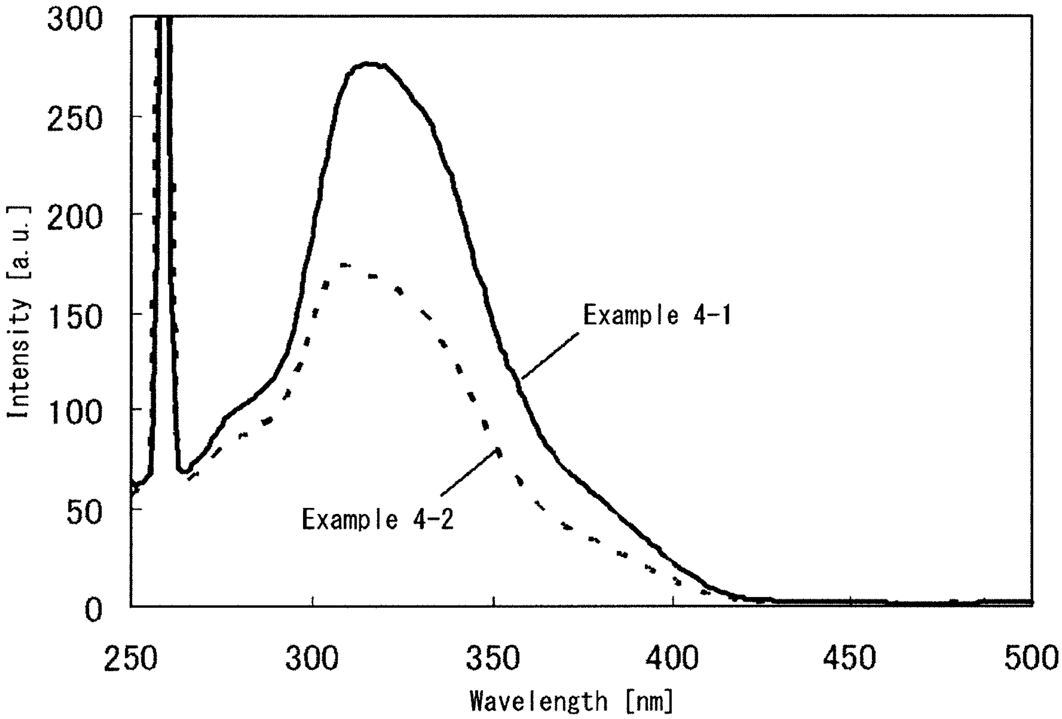
300
250
200
150
100
50
0
Intensity [a.u.]
250
300
350
400
450
500
Wavelength [nm]
Example 4-1
Example 4-2

Fig. 4

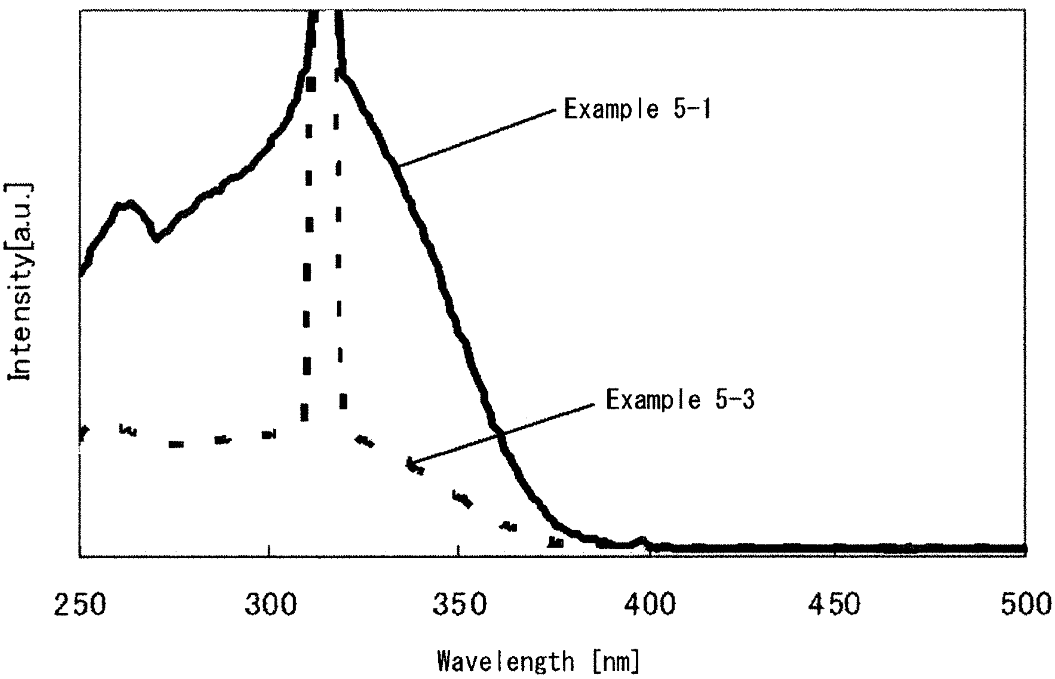
Intensity[a.u.]
250
300
350
400
450
500
Wavelength [nm]
Example 5-1
Example 5-3

Fig. 5

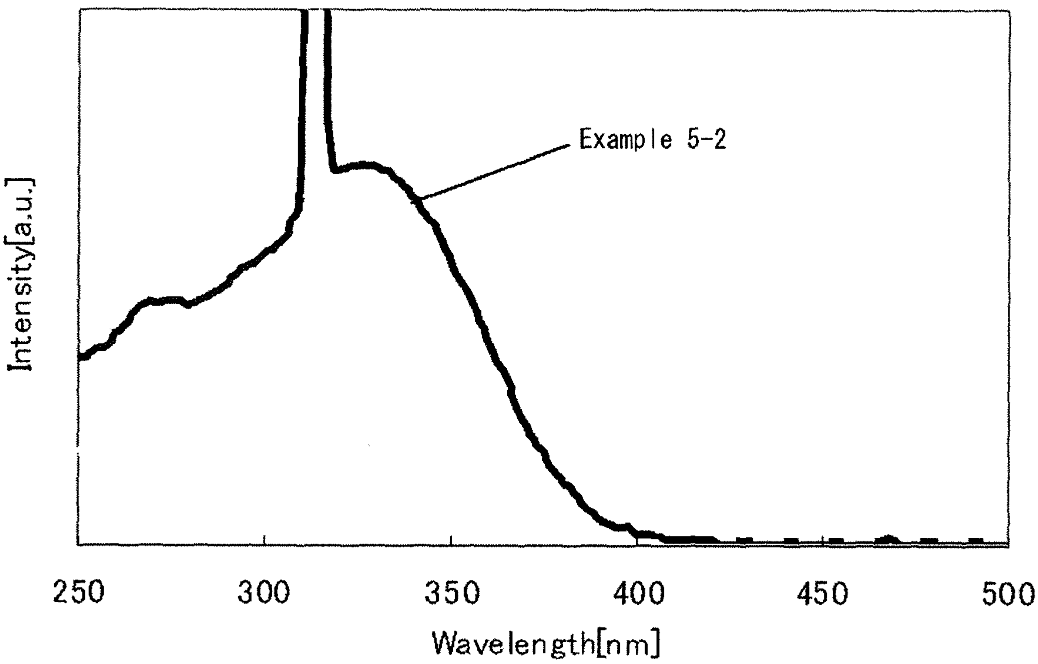
Example 5-2
Intensity[a.u.]
250
300
350
400
450
500
Wavelength[nm]

## INTERNATIONAL SEARCH REPORT

International application No. PCT/JP2013/056539

**A. CLASSIFICATION OF SUBJECT MATTER**

*C08F2/44*(2006.01)i, *C09K11/08*(2006.01)i, *H01L31/04*(2006.01)i

According to International Patent Classification (IPC) or to both national classification and IPC

**B. FIELDS SEARCHED**

Minimum documentation searched (classification system followed by classification symbols)

C08F2/44, C09K11/08, H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2011-222749 A (Hitachi Chemical Co., Ltd.), 04 November 2011 (04.11.2011), claims; paragraphs [0001], [0062] to [0066]; examples (Family: none) | 1,5-20<br>2-4 |
| X | JP 2008-111112 A (Samsung Electro-Mechanics Co., Ltd.), 15 May 2008 (15.05.2008), claims; paragraph [0031]; examples & US 2008/0103276 A1 & KR 10-2008-0037987 A | 1-20 |
| A | JP 2012-41465 A (Hitachi Chemical Co., Ltd.), 01 March 2012 (01.03.2012), the entire specification & WO 2011/126118 A1 & TW 201139606 A | 1-20 |

☐ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| | |
|---|---|
| Date of the actual completion of the international search<br>22 March, 2013 (22.03.13) | Date of mailing of the international search report<br>02 April, 2013 (02.04.13) |
| Name and mailing address of the ISA/<br>Japanese Patent Office<br>Facsimile No. | Authorized officer<br>Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H10110004 A
- JP S6365085 A
- JP 2003218379 A
- JP 2006303033 A
- JP 2012063499 A
- JP 2012063500 A
- JP 2012174900 A
- JP 2012174903 A
- JP 2012182280 A